# EUROPEAN PATENT SPECIFICATION

(11) **EP 2 732 078 B1**
(45) Date of publication and mention of the grant of the patent: **15.03.2017**
(21) Application number: 12737684.6
(22) Date of filing: 13.07.2012
(51) Int. Cl.: C30B 7/00, C30B 29/60, B01F 11/02

(54) **METHODS FOR PREPARING NANOCRYSTALLINE COMPOSITIONS USING FOCUSED ACOUSTICS**
VERFAHREN ZUR HERSTELLUNG NANOKRISTALLINER ZUSAMMENSETZUNGEN MITTELS FOKUSSIERTER AKUSTIK
PROCÉDÉS DE FABRICATION DE COMPOSITIONS NANOCRISTALLINES AU MOYEN D'ÉNERGIE ACOUSTIQUE FOCALISÉE

(30) Priority: 14.07.2011 US 201161507944 P
(43) Date of publication of application: 21.05.2014
(73) Proprietor: Covaris, Inc., Woburn MA 01801-1721 (US)
(72) Inventor: BECKETT, Carl, Harvard, MA 01451 (US); LAUGHARN, James, A., Jr., Winchester, MA 01890 (US); KAKUMANU, Srikanth, North Billerica, MA 01862 (US)
(74) Representative: Hoffmann Eitle
(86) International application number: PCT/US2012/046636
(87) International publication number: WO 2013/010066

(56) References cited:
- EP-A1- 1 925 359
- WO-A1-02/089942
- WO-A1-03/061816
- WO-A1-2010/079843
- WO-A1-2012/061237
- WO-A2-2008/016691
- WO-A2-2012/003003
- US-A- 2 589 310
- US-A1- 2006 158 956
- US-B1- 6 719 449
- US-B2- 6 948 843
- US-B2- 7 128 784
- US-B2- 7 521 023
- US-B2- 7 687 026

## Description

### BACKGROUND

### 1. Field of Invention

Aspects described herein relate to the use of focused acoustic energy to prepare nanocrystalline compositions. In some cases, nanocrystalline compositions and associated systems and methods discussed herein may have application in fields related to the delivery of bioactive agents.

### 2. Related Art

Acoustic treatment systems can be used to expose samples to an acoustic field. Samples that may undergo acoustic treatment include genetic material (e.g., DNA, RNA), tissue material (e.g., bone, connective tissue, vascular tissue), plant material (e.g., leaves, seeds), cells and other substances. Acoustic treatment systems may be used to treat biological and/or non-biological items. In some arrangements, the acoustic energy can be relatively intense, causing the sample material to be fragmented, lysed or otherwise disrupted. For example, a sample containing a plurality of cells may be exposed to acoustic treatment such that cell membranes and other components are broken down or otherwise degraded so that DNA or other genetic material is released into a liquid. The genetic material may then be collected and used for various types of analyses. Acoustic treatment systems generate a suitable acoustic field for these processes using an acoustic transducer. The acoustic field may be focused or otherwise arranged so as to cause the desired effect on the sample material. Examples of such systems are described in U.S. Patent Nos. 6,948,843; 6,719,449; 7,521,023; and 7,687,026.
WO2012003003 (A2) relates to the use of focused acoustic energy to prepare formulations (e.g., nanoformulations) and/or systems for nano-delivery.
EP1925359 (A1) relates to a method of forming solid particles from a sample, which includes the step of exposing the sample to a focused acoustic field having an acoustic wave variable, until the solid particles achieve a desired state of particularization.
WO2008016691 (A2) relates to systems and methods for applying acoustic energy to a sample.

### SUMMARY

Aspects described herein relate to methods for preparing nanocrystalline compositions using focused ultrasonic acoustic processing. In particular, focused ultrasonic acoustical energy may be applied to a sample having a generally large volume (e.g., greater than the volume of a sample that is typically held in a test tube or greater than 30 mL) in a manner that induces crystal growth in the sample and resulting in a plurality of stable nanocrystalline particles having submicron features. In some embodiments, nanocrystalline particles may be formed as a suspension of particles in a liquid solution. In some cases, though not required, nanocrystalline particles may be provided as agents in delivery systems for bioactive agents, such as pharmaceuticals and/or other therapeutic compounds.

The preparation of large volumes of nanocrystalline compositions is not a requirement of the present disclosure. For example, aspects relating to the control of certain process parameters, such as the number of cycles per burst, duty cycle, duration of focused acoustic treatment, power level of the focused acoustic field, have been found to be effective in producing suitable nanocrystalline compositions described herein.

In preparing a nanocrystalline composition, a sample having, for example, a generally large volume may be disposed and/or introduced in a vessel having a processing region or chamber and at least a portion of the sample may be exposed to a focal zone of acoustic energy having a size dimension of less than 2 centimeters. The focused acoustic field may be generated from an acoustic energy source operated at a suitable power level for certain period(s) of time under appropriate conditions such that upon sufficient exposure of the mixture to the focal zone of the acoustic field, a stable nanocrystalline composition having a plurality of particles with an average size greater than about 10 nm may result. For example, the acoustic energy source may generate a focused acoustic field in a pulsed fashion and may produce a large number of cycles per burst (e.g., up to 5000 cycles per burst).

In some cases, the focused acoustic field may serve to nucleate sites within the sample, giving rise to crystal growth of nanoparticles at the nucleation sites. The focused acoustic field may also augment crystal growth of nanoparticles, causing crystals to grow in the sample at a faster rate than the rate of crystal growth of nanoparticles if the sample were not further subject to the focused acoustic field. In some embodiments, a focused acoustic field may function in not only causing nucleation of sites within the sample at which crystal growth may subsequently occur, the focused acoustic field may also break off portions of crystalline material having grown within the sample. Although an appropriate focused acoustic field may break off pieces of crystalline material at certain locations within the sample, in some instances, subcrystals may grow at the regions of crystal where a fracture had occurred. In some cases, a subcrystal may grow from the portion of crystal that remains, or in some cases, a subcrystal may grow from the portion of crystal that had been broken off of the main crystal.

High volumes of sample may be processed through focused acoustics to form nanocrystalline particles through crystal growth, such as samples greater than 50 mL, greater than 100 mL, greater than 1 L, or even greater. In some embodiments, a flow through system may be used to acoustically treat a sample having a high volume. For example, the sample may flow through a process chamber of the vessel in a manner such that the sample is exposed to the focal zone of the focused acoustic field while disposed in the process chamber. In various embodiments, suitable preparation of nanocrystalline compositions described herein do not require a flow through system. For example, a sample may be processed using focused acoustics to form a nanocrystalline composition in a process chamber not having an inlet or outlet, such as a test tube, pipette or multiwell plate.

In some cases, the process chamber may have a volume that is less than the total volume of the sample. For example, a portion of the sample may pass through the process chamber and be subject to focused acoustic treatment. The portion of sample having been subject to focused acoustic treatment may then move to another location in or outside of the system.

Various portions of sample may be acoustically treated a single time or multiple times. For example, the sample may flow cyclically between the process chamber and a reservoir. Or, the sample may flow through a system having multiple process chambers and be acoustically processed in each of the process chambers. In some embodiments, the process chamber may be an elongated conduit and the focal zone of the focused acoustic field may also be elongated so as to acoustically treat the sample as the sample flows through the process chamber. The flow rate of at least a portion of the sample through the vessel (e.g., through the process chamber) may be at least 0.1 mL/min, or between about 0.5 mL/min and about 100 mL/min. Using a flow through arrangement, there is no limit as to the volume of sample material that may be acoustically processed.

Certain parameters of the focused acoustic field, such as the cycles per burst, may play a role in suitably producing a nanocrystalline composition. In some cases, nucleation of sites for crystal growth and/or crystal growth itself may be enhanced upon appropriately adjusting the cycles per burst of the focused acoustic field. In some embodiments, the focused acoustic field may be operated within a range of between 1000 cycles per burst and 6000 cycles per burst. For example, a focused acoustic field used for preparing nanocrystalline compositions may be operated at greater than 1000 cycles per burst, greater than 2000 cycles per burst, greater than 3000 cycles per burst, greater than 4000 cycles per burst, greater than 5000 cycles per burst, or greater than 6000 cycles per burst. In some situations, when a sample is subjected to a focused acoustic field having an appropriate amount of cycles per burst (e.g., 5000 cycles per burst), a stable nanocrystalline composition with a tight particle size distribution may result.

According to the invention as set forth in claim 1, a method of preparing a nanocrystalline composition is provided. The method includes providing at least a portion of a sample comprising a volume of greater than 30 mL in a vessel; transmitting focused acoustic energy greater than 1000 cycles per burst having a frequency of between about 100 kilohertz and about 100 megahertz and a focal zone having a size dimension of less than about 2 centimeters through a wall of the vessel such that the sample is disposed at least partially in the focal zone; and forming, through crystal growth, a plurality of crystalline particles in the sample having an average size of greater than about 10 nm and a polydispersity index of less than 1.0 as calculated according to the International Standard on dynamic light scattering ISO 13321, by, at least in part, exposure of the sample to the focal zone.

In a further illustrative embodiment, a method of preparing a nanocrystalline composition is provided. The method includes providing at least a portion of a sample comprising a volume of greater than 30 mL in a vessel; transmitting focused acoustic energy between 1000 cycles per burst and 6000 cycles per burst having a frequency of between about 100 kilohertz and about 100 megahertz and a focal zone having a size dimension of less than about 2 centimeters through a wall of the vessel such that at least a portion of the sample is disposed in the focal zone; and forming, through crystal growth, a plurality of crystalline particles in the sample having an average size greater than 10 nm and a polydispersity index of less than 1.0 as calculated according to the International Standard on dynamic light scattering ISO 13321, by, at least in part, exposure of the sample to the focal zone.

In another illustrative embodiment, a sample comprising a volume of greater than 30 mL disposed in the vessel, the vessel constructed and arranged to cause flow of a portion of the sample in the vessel at a rate of at least 0.1 mL/min; and an acoustic energy source spaced from and exterior to the vessel and adapted to emit focused acoustic energy having a frequency of between about 100 kHz and about 100 MHz and a focal zone having a size of less than about 2 cm through a wall of the vessel such that the sample is disposed at least partially in the focal zone, wherein, upon exposure of the sample to the focal zone for a period of time, the sample comprises a plurality of crystalline particles formed through crystal growth and having an average size of greater than about 10 nm and a polydispersity index of less than 1.0 as calculated according to the International Standard on dynamic light scattering ISO 13321.

Various embodiments of the present invention provide certain advantages. Not all embodiments of the invention share the same advantages and those that do may not share them under all circumstances.

Further features and advantages of the present invention, as well as the structure of various embodiments of the present invention are described in detail below with reference to the accompanying drawings.

### BRIEF DESCRIPTION OF THE DRAWINGS

Non-limiting embodiments of the present invention will be described by way of example with reference to the accompanying figures, which are schematic and are not intended to be drawn to scale. In the figures, each identical or nearly identical component illustrated is typically represented by a single numeral. For purposes of clarity, not every component is labeled in every figure, nor is every component of each embodiment of the invention shown where illustration is not necessary to allow those of ordinary skill in the art to understand the invention. In the figures:
Fig. 1 shows a schematic diagram of an acoustic treatment system in accordance with an illustrative embodiment;
Fig. 2 illustrates a schematic diagram of another acoustic treatment system in accordance with an illustrative embodiment;
Fig. 3 depicts a schematic diagram of a further acoustic treatment system in accordance with an illustrative embodiment;
Fig. 4 shows a schematic diagram of a different acoustic treatment system in accordance with an illustrative embodiment;
Fig. 5 illustrates a schematic diagram of yet another acoustic treatment system in accordance with an illustrative embodiment;
Fig. 6 illustrates a schematic diagram of a process chamber of an acoustic treatment system in accordance with an illustrative embodiment;
Fig. 7 depicts a particle size distribution of a sample in accordance with an example;
Fig. 8 depicts a particle size distribution of a sample in accordance with another example;
Fig. 9 illustrates the particle size distribution of the sample of Fig. 8 after a period of time;
Fig. 10 depicts a particle size distribution of a sample in accordance with a different example;
Fig. 11 illustrates the particle size distribution of the sample of Fig. 10 after a period of time;
Fig. 12 depicts a particle size distribution of a sample in accordance with yet another example;
Fig. 13 illustrates the particle size distribution of the sample of Fig. 12 after a period of time;
Fig. 14 depicts a particle size distribution of a sample in accordance with another example;
Fig. 15 illustrates the particle size distribution of the sample of Fig. 14 after a period of time;
Fig. 16 is an exploded perspective view of an acoustic treatment system in an embodiment including a chamber that is received in a vessel;
Fig. 17 is a cross sectional view of the Fig. 16 embodiment in an assembled condition;
Fig. 18 is a cross sectional view of an acoustic treatment chamber having a jacketed heat exchanging system;
Fig. 19 is a cross sectional view of an acoustic treatment chamber having an insert element in one illustrative embodiment;
Fig. 20 is a cross sectional view of an acoustic treatment chamber having an insert element that includes suspended rods and spherical elements in an illustrative embodiment;
Fig. 21 is an illustrative embodiment of an acoustic treatment system including a reservoir with an agitator;
Fig. 22 is an illustrative embodiment of an acoustic treatment system arranged for oscillating flow of material;
Fig. 23 is an illustrative embodiment of an acoustic treatment system arranged for serial treatment of material using multiple treatment chambers;
Fig. 24 shows a schematic diagram of an acoustic treatment system in an embodiment;
Fig. 25 is a cross sectional view of an acoustic treatment chamber in another illustrative embodiment;
Fig. 26 is a perspective view of the acoustic treatment chamber of Fig. 24;
Fig. 27 is a cross sectional view of an acoustic treatment chamber having a dome with a conical shape;
Fig. 28 is a cross sectional view of an acoustic treatment chamber having a dome with a cylindrical shape; and
Fig. 29 is a cross sectional view of an acoustic treatment chamber having a dome with a conical and a cylindrical portion.

### DETAILED DESCRIPTION

The present disclosure relates to methods of using focused acoustics for quickly and efficiently preparing large volumes of nanocrystalline compositions. Processes described herein may be repeatable, controllable, yield results quickly, avoid cross-contamination of sample material and/or can be isothermal (i.e., avoids over-heating of the sample upon acoustic treatment). Nanocrystalline compositions and the ability to create large or small volumes of them in a simple, convenient manner may be useful for furthering existing methods of therapeutic delivery as well as preparing systems for therapeutic delivery. In some embodiments, samples may be exposed to a focused acoustic field in a manner that causes crystal growth within the sample, forming nanocrystalline compositions. For example, large volumes of sample such as a volume of greater than about 30 mL (e.g., greater than the volume of a sample typically found in a test tube or multiwell plate) may be treated with focused acoustics so as to result in crystal growth in the sample. The nanocrystalline particles generally have an average particle size of greater than 10 nm or between 10 nm and 1 micron and a narrow particle size distribution (e.g., polydispersity index less than 1.0 or less than 0.1).

In some embodiments, at least a portion of the sample may be flowed through the vessel (e.g., through a process chamber) during focused acoustic processing at a rate of at least 0.1 mL/min. Other arrangements not including a flow through system may be used for treating a sample with a focused acoustic field. In some embodiments, a focused acoustic field may be generated to process a sample in forming a nanocrystalline composition in a process chamber that does not have an inlet or outlet, for example, a test tube, pipette, multiwell plate or other suitable arrangement (e.g., an enclosed chamber, mixing vessel, etc.).

"Sonic energy" as used herein is intended to encompass such terms as acoustic energy, acoustic waves, acoustic pulses, ultrasonic energy, ultrasonic waves, ultrasound, shock waves, sound energy, sound waves, sonic pulses, pulses, waves, or any other grammatical form of these terms, as well as any other type of energy that has similar characteristics to sonic energy. "Focal zone" or "focal point" as used herein means an area where sonic energy converges and/or impinges on a target, although that area of convergence is not necessarily a single focused point, but may include a volume of varying size and shape. As used herein, the terms "process chamber" or "processing zone" as used herein means a vessel or region where the sonic energy converges, and the sample material is present for treatment. As used herein, "nonlinear acoustics" can mean lack of proportionality between input and output. For example, as the amplitude applied to the acoustic transducer increases, the sinusoidal output loses proportionality such that eventually the peak positive pressure increases at a higher rate than the peak negative pressure. Also, water becomes nonlinear at high acoustic energy intensities, and in a converging acoustic field, the waves become more disturbed as the intensity increases toward the focal point. Nonlinear acoustic properties of tissue can be useful in diagnostic and therapeutic applications. As used herein, "acoustic streaming" can mean generation of fluid flow by acoustic waves. The effect can be non-linear. Bulk fluid flow of a liquid in the direction of the sound field can be created as a result of momentum absorbed from the acoustic field. As used herein, "acoustic micro-streaming" can mean time-independent circulation that occurs only in a small region of the fluid around a source or obstacle, for example, an acoustically driven bubble in a sound field. As used herein, "acoustic absorption" can refer to a characteristic of a material relating to the material's ability to convert acoustic energy into thermal energy. As used herein, "acoustic impedance" can mean a ratio of sound pressure on a surface to sound flux through the surface, the ratio having a reactance and a resistance component. As used herein, "acoustic window" can mean a system or device for allowing sonic energy to pass through to the sample within the processing chamber or zone. As used herein, "acoustic lens" can mean a system or device for spreading, converging or otherwise directing sounds waves. As used herein, "acoustic scattering" can mean irregular and multi-directional reflection and diffraction of sound waves produced by multiple reflecting surfaces, the dimensions of which are small compared to the wavelength, or by certain discontinuities in the medium through which the wave is propagated.

Although ultrasonics have been utilized for a variety of diagnostic, therapeutic, and research purposes, the biophysical, chemical, and mechanical effects are generally only empirically understood. Some uses of sonic or acoustic energy in materials processing include "sonication," which is an unrefined process of mechanical disruption involving the direct immersion of an unfocused ultrasound source emitting energy in the low kilohertz (kHz) range (e.g., 15 kHz) into a fluid suspension of the material being treated. Accordingly, the sonic energy produces inconsistent results due to the unfocused and random nature of the acoustic waves and are prone to induce sample overheating, as the energy is scattered, absorbed and/or not properly aligned with the target.

In contrast to some prior uses of sonic energy, the use of "focused acoustics" as described herein in the preparation of nanocrystalline compositions has significant benefits, including those listed below. Focused acoustics provides a distinct benefit in that it allows for stable and reproducible preparation of nanocrystalline compositions having a desired particle size distribution (e.g., having a suitable range of particle size with a narrow distribution). Focused acoustics also provides for the processing and preparation of nanocrystalline compositions with little or no adverse heating of the sample during acoustic processing (e.g., providing the ability to acoustically treat a sample isothermally). Compositions may be processed in a contained environment, i.e., a closed system, enabling sterile non-contact operation without risk of contamination. Focused acoustic treatment is highly scalable to sample sizes having volumes larger than that of typical sample volumes held in single-use containers, such as a test tube, pipette tip or multiwall plate. Additionally, focused acoustic methods described herein may involve a simple process operation that requires a small amount of labor, and a generally low operator skill set than that required of conventional sonication or methods of applying acoustic energy to sample materials. Focused acoustics may be used in accordance with adaptive focused acoustics (AFA) methods provided by Covaris, Inc, Woburn, MA.

A focused acoustic fields may be employed to create nucleation sites within a sample where crystal growth of nanoparticles are permitted to occur at the nucleation sites. In some cases, nucleation occurs at a level just beyond that of saturation in the sample where effects of crystallization and precipitation of crystals overcome the tendency of the crystallizing compound to re-dissolve in the solution. Once the nucleation sites are formed, crystal growth may occur with or without further exposure to the focused acoustic energy. However, further exposure to the focused acoustic energy may enhance the rate of crystal growth of the nanoparticles. Though, in some cases, the rate of crystal growth remains unaffected by further exposure to the focused acoustic field beyond initial nucleation. While nucleation and crystal growth may occur at the same time, depending on various conditions of the focused acoustic treatment, one of nucleation or crystal growth may be adjusted to predominate over the other, controllably yielding nanocrystalline materials having a variety of shapes and sizes, in a reproducible manner.

As nanocrystalline particles experience crystal growth and agglomeration, a focused acoustic field may disrupt the agglomerations of particles in manner where portions of the nanocrystalline particles and/or agglomerations are broken into two or more pieces. In some embodiments, the region of fracture of the nanocrystalline particles may, in turn, serve as nucleation sites for further crystal growth of subcrystals within the sample to occur. Accordingly, focused acoustics may instigate and propagate a dynamic process where crystals are growing within the sample, yet the crystals are also broken/fractured, giving rise to nucleation sites where further crystal growth occurs at the nucleation sites. Such a process of crystal growth and micronization within the sample may result in a formulation having a stable, tight particle size distribution with a submicron average particle size.

In forming nanocrystalline compositions with preferred characteristics, a number of factors may come into play, such as for example, the time under which the sample is acoustically processed; the time under which the sample is not subject to focused acoustics; whether additional material (e.g., co-former, seed crystal/material, etc.) is added to the sample prior to, during or after acoustic treatment; the nature of the sample material itself (e.g., the tendency of the material for crystal growth); the concentration of the composition to be crystallized within the sample; the temperature of the sample (e.g., whether treatment occurs isothermally, or with a gradual decrease in temperature); the power output of the acoustic transducer in creating the focused acoustic field; the pattern of focused acoustic output (e.g., pulsed acoustics, cycles per burst, etc.); the flow rate of sample through the process chamber; the number of times the sample is treated with a focused acoustic field; or other influential factors.

In some embodiments, a focused acoustic field may be applied to a sample to create a nucleation site and then the acoustic transducer may be turned off so that the crystals grow in the absence of the focused acoustic energy. Such an arrangement, in some cases, may give rise to larger crystals being formed due to a lack of disruptive forces as compared to a resulting sample having continued exposure to the focused acoustic energy.

Focused acoustic energy may be applied to a sample to induce crystallization according to any suitable protocol. In some instances, focused acoustic energy is provided in a pulsed manner which may create a cyclical effect involving compressive and expansive forces. As such, in some cases, pulsed focused acoustics may create an environment where crystal sites are nucleated and subsequent crystals are given the space and energy predictably grow. In some embodiments, the sample is exposed to the focused acoustic energy at intermittent time periods. For example, the sample may be processed by a focused acoustic field for a first period of time (e.g., less than 1 minute) and then the sample may be allowed to remain for a period of time (e.g., less than 1 minute) without being subject to the focused acoustic field. The sample may subsequently be processed again in a repeated fashion in a manner that gives rise to a stable nanocrystalline composition having a desired particle size distribution and morphology. Accordingly, depending on the protocol of focused acoustic treatment, the particle size distribution of nanocrystalline particles may be suitably controlled.

Prior to focused acoustic processing, samples may exhibit any suitable formulation. In some embodiments, before exposure to a focused acoustic field, a sample may be in the form of a solution not including any particles within the solution. Accordingly, when the sample is exposed to focused acoustic energy, small particles precipitate out of solution and serve as nucleation sites for crystal growth to occur on the particles. In some embodiments, before the sample is exposed to a focused acoustic field, the sample may be in the form of a suspension or an emulsion where small particles or insoluble components are already included within the sample. As such, the focused acoustic field may function to create nucleation sites on the particles in suspension and/or augment crystal growth of the particles within the sample.

The inventors have recognized and appreciated that a substantial amount of chemical compositions produced by the pharmaceutical industry, with a number of existing drugs currently on the market, are lipophilic (poorly soluble) compounds. As a result of such poor solubility, pharmaceutical agents tend to exhibit a short biological half-life, poor bioavailability, prominent adverse effects and an overall decreased stability. It then follows that to evaluate such compositions at the preclinical stage, the composition is often dosed orally as an aqueous-based suspension. A downside to dosing an aqueous-based suspension is that detrimental in vivo consequences may arise, such as decreased bioavailability and higher inter-subject variability, as compared to dosing with a solution formulation. Bioavailability refers to the percentage of an administered dose of a drug that reaches systemic circulation through bodily absorption and/or metabolism. A solution formulation, in contrast, is not easily attainable using conventional methods without either toxic levels of excipients and/or considerable resources expended, thus making early stage evaluation of a high number of compounds impractical. Producing formulations (e.g., suspensions) having nanocrystalline compositions with a relatively small average particle size that remains stable may help to mitigate some of the aforementioned problems.

Although small particles may be produced through mechanical processes such as milling, such processes may damage or detrimentally affect the material properties (e.g., morphology) of the milled particles. In some therapeutic applications, such as pharmaceutical inhalation or oral administration, the shape of the particles may affect how the particles are taken up by the body. As a result, focused acoustic treatment may be used to reproducibly produce nanocrystalline compositions having preferred morphologies and particle size distributions.

Particle size distributions of nanocrystalline compositions described herein may be measured using any suitable method. In some embodiments particle size distributions are measured using dynamic laser light scattering, also called Photon correlation spectroscopy (e.g., using Malvern Zetasizer-S, Zetasizer Nano ZS-90 or Mastersizer 2000 instruments; Malvern Instruments Inc.; Southborough MA). The Malvern Zetasizer-S instrument was used to estimate average particle sizes with a 4mW He-Ne laser operating at a wavelength of 633nm and an avalanche photodiode detector (APD). The average size of particles in a nanocrystalline composition may be estimated as the mean hydrodynamic size. The particle size distribution may be estimated according to polydispersity index (PDI), which is known in the art as a measure of the tightness of a distribution. The average size of particles and the PDI of nanocrystalline compositions discussed herein are calculated according to the International Standard on dynamic light scattering, ISO 13321.

Particles of nanocrystalline compositions may have any three dimensional shape, such as a cuboid, parallelepiped, hexahedron, polyhedron, etc. It can be appreciated that the term "particle size," as used herein, may refer to an estimated particle size as assessed by methods known in the art. Although crystal materials produced by systems and methods described are generally faceted in nature, particle size may refer to an estimated diameter of a particle assuming a generally spherical shape according to the above light scattering measurement methods. Or, particle size may refer to an estimated width, length or other dimension of a polyhedron, such as a cuboid or parallelepiped. In some cases, particle size can be estimated using high resolution microscopy, such as electron microscopy (e.g., SEM, TEM, etc.) or atomic force microscopy.

The average particle size of nanocrystalline compositions prepared by focused acoustic systems and methods described herein may suitably vary depending on the application and the materials that are crystallized. In some embodiments, the average particle size of nanocrystalline compositions having been processed through focused acoustic treatment is between 10 nm and 1 micron, between 100 nm and 900 nm, between 500 nm and 900 nm, between 500 nm and 700 nm, between 100 nm and 500 nm, between 100 nm and 300 nm.

Focused acoustic treatment processes may be scaled up to acoustically treat any appropriate volume of sample material in accordance with systems and methods provided herein. In some embodiments, a treatment vessel may have one or more suitable inlets and/or outlets that permit sample material to flow into and out of the vessel or a process chamber of the vessel. Once suitably disposed in the vessel or process chamber, the sample material may be subject to focused acoustic treatment under an appropriate set of conditions. After a sufficient degree of focused acoustic treatment, the sample material may be discharged from the vessel or process chamber, allowing more sample that had not been previously treated to be subject to focused acoustic treatment. For various embodiments described herein, a treatment vessel may be considered to be equivalent to a process chamber.

In some embodiments, an acoustic treatment system may include a reservoir and a process chamber, each having inlets and outlets that are in fluid communication with one another; that is, fluid is permitted to travel between the reservoir and the process chamber via suitable conduits. Accordingly, sample material from the reservoir may be caused to travel to the process chamber for focused acoustic treatment under appropriate conditions and may subsequently be caused to travel back to the reservoir. As a result, sample material may be acoustically processed in a cyclic fashion where portions of sample material may receive focused acoustic treatment multiple times.

In some embodiments, sample material may travel from a supply reservoir to a process chamber for focused acoustic treatment. The treated sample material may subsequently travel from the process chamber to a different container separate from the supply reservoir. As such, the sample material may undergo a single acoustic treatment.

In some embodiments, sample material may travel from a supply reservoir through multiple process chambers for varying levels of processing, such as different conditions of focused acoustics. Additional conduits may also be provided for the addition/removal of sample material, which may serve to enhance crystallization or may increase/decrease the rate of crystal growth. In an example, an additional material may be introduced into the sample through a conduit and, upon combination with the sample material, crystalline nucleation, precipitation and/or growth may be augmented.

In some embodiments, the process chamber is a conduit through which sample material flows. As such, the sample may receive focused acoustic treatment from multiple transducers and/or the sample may receive focused acoustic treatment from a transducer that generates a focal zone that is shaped in a manner that traverses a substantial distance of the process chamber conduit.

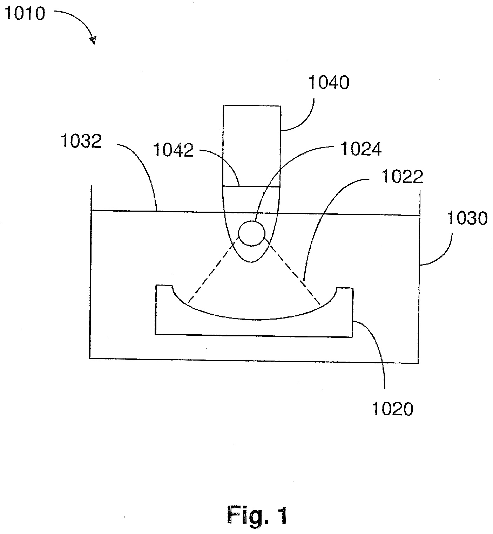

Fig. 1 illustrates a focused acoustic processing system 1010 in accordance with systems described in U.S. Patent Nos. 6,948,843; 6,719,449; and 7,521,023. The system utilizes a piezoelectric transducer 1020 to generate acoustic energy waves 1022 directed toward a sample 1042 that is contained within space defined by a process vessel 1040. The process vessel 40 is positioned within a fluid bath container 1030 having an acoustic coupling medium 1032 (e.g., water) located therein and in contact with an exterior surface of the process vessel. Acoustic energy waves 1022 are transmitted from the transducer 1020, through the medium 1032, through a wall of the process vessel 1040 and converge in a focal zone 1024 within or near the walls of the process vessel. The frequency of the acoustic waves may have any suitable range, such as between about 100 kilohertz and about 100 megahertz, or between about 500 kilohertz and about 10 megahertz. The focal zone 1024 is in close proximity to the sample 1042 such that non-contact isothermal mechanical energy is applied to the sample 1042. The focal zone may have any suitable shape and size, such as having a size dimension (e.g., width, diameter) of less than 2 cm, less than 1 cm, or less than 1 mm.

As discussed above, the inventors have recognized and appreciated that it would be advantageous for treatment processes of sample material with focused acoustic systems to be scaled up for treatment of larger volumes of material. Although the system of Fig. 1 may incorporate mechanical and/or electrical mechanisms that allow for relative movement between a transducer and a process vessel, the sample material is generally contained within the space defined by the vessel 1040. As such, to treat subsequent sample material, the transducer and/or the process vessel should be displaced relative to one another. As an example, once a sample material contained within a test tube (i.e., process vessel) is fully treated, the test tube is moved away from the transducer so that a subsequent process vessel containing a different sample material can be moved into a suitable position for focused acoustic treatment. Or, when sample material contained in one well of a microplate is sufficiently treated, the microplate may be moved relative to the transducer such that a neighboring well containing a different sample material is placed in a suitable position for processing.

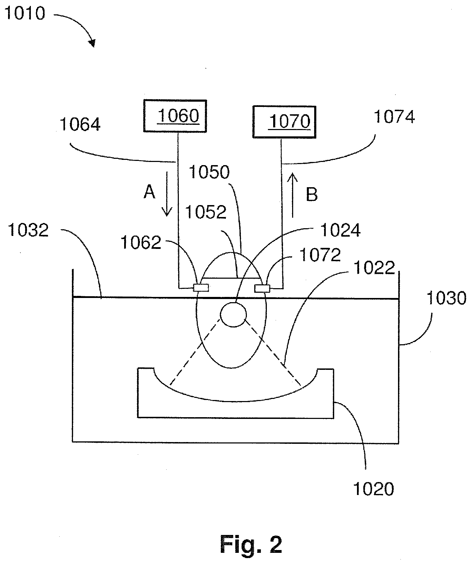

Fig. 2 depicts an acoustic processing system 1010 that allows for inflow and outflow of sample material without need for the transducer 1020 or a process chamber 1050 (or process vessel) to be moved. The system of Fig. 2 is generally similar to the system shown in Fig. 1 including a process chamber 1050 having sample material 1052 disposed therein; however, the system also includes a sample source 1060 and a sample drain 1070. The process chamber 1050 includes an inlet 1062 in fluid communication with a conduit 1064 for permitting an inflow of sample material from the source 1060 through conduit 1064 along the direction of arrow A and into the process chamber 1050. The process chamber also includes an outlet 1072 that permits an outflow of sample material from the process chamber and into a conduit 1074 along the direction of arrow B that provides for fluid flow of sample material to the drain 1070.

Accordingly, the system of Fig. 2 provides the ability for untreated sample material to travel through the system vessel, into the process chamber, be treated with focused acoustic energy and subsequently travel out of the process chamber. Such a system allows for a large volume of sample material to be treated with focused acoustics while not requiring movement of the process chamber or the transducer relative to one another. As mentioned previously, the amount of sample material that can be processed in such a system is unlimited, as sample material can continuously flow through the process chamber and, hence, be subject to focused acoustic treatment. The source 1060 may be a finite reservoir containing a limited volume of sample material to be treated, or alternatively, the source may draw from a continual supply of sample material for acoustic processing, such as a reservoir that is constantly replenished. Similarly, the drain10 70 may be a container that holds a finite volume of already treated sample material, or, for example, the drain may feed a larger body or reservoir of treated sample material that is continuously drawn from for suitable purposes/applications.

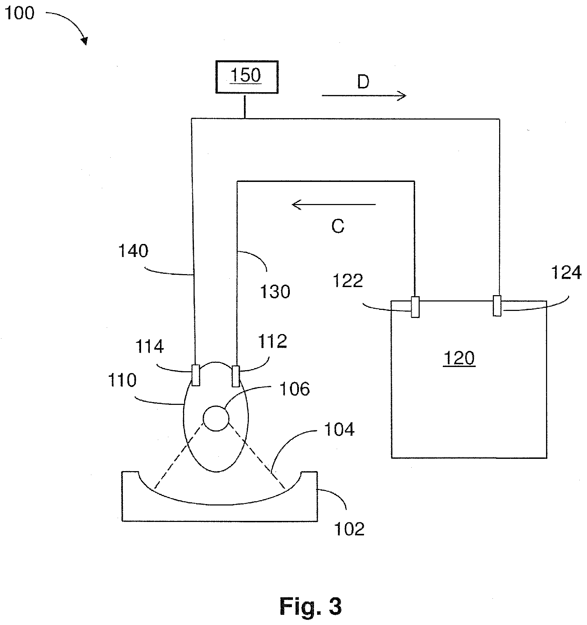

In some embodiments, large and/or small volumes of sample may be processed through focused acoustics to form nanocrystalline particles, via crystal growth, such as samples greater than 30 mL, greater than 50 mL, greater than 100 mL, greater than 1 L, or even greater. Fig. 3 depicts another illustrative embodiment of a focused acoustic processing system 100 that enables a scaled up approach for treating sample material with focused acoustics. The system provides for the ability for sample material to be treated multiple times. The system includes a reservoir 120 for holding a supply of sample material and a process chamber 110 which provides a space for sample material to undergo acoustic treatment. The reservoir 120 includes a reservoir outlet 122 and a reservoir inlet 124 for permitting inflow and outflow of sample material to and from the reservoir. Similarly, the process chamber 110 includes a chamber inlet 112 and a chamber outlet 114 for permitting inflow and outflow of sample material to and from the process chamber. The reservoir outlet 122 permits sample material to travel along the direction of arrow C from the reservoir into a conduit 130 and further into the process chamber via chamber inlet 112. Upon sufficient acoustic treatment of the sample material, an appropriate amount of sample material may exit from the process chamber via chamber outlet 114, into a conduit 140 so as to travel along the direction of arrow D and back into the reservoir 120 via reservoir inlet 124.

Accordingly, a larger amount of sample material may be acoustically treated in the overall system vessel than the volume which is defined by the space of the process chamber. The only limitation as to how much volume of sample material may be treated with such a vessel depends on the size of the reservoir, which can be any suitable volume. In addition, sample material may be acoustically treated multiple times as already-processed material that is transported back into the reservoir from the process chamber may ultimately be caused to move from the reservoir back into the process chamber for further acoustic treatment.

Any suitable structure may be provided as an inlet and/or outlet, as described herein. For example, appropriate inlets and outlets may include a nozzle, hole, tubing, conduit, etc. In some cases, inlets and/or outlets may include a valved structure that opens and closes to control inflow and outflow of material when desired. In addition, the process chamber and reservoir are not limited in the number and location of inlets/outlets. For example, the process chamber and/or reservoir may have an additional inlet or outlet for flow of sample material to other suitable locations beside conduits 130, 140.

Any suitable motive force may be provided for causing movement of sample material between the reservoir and the process chamber (e.g., through conduits 130, 140 and respective inlets/outlets). In some embodiments, a pump 150 is provided to apply pressure to the sample material for moving the sample material from the reservoir to the process chamber and back. Any appropriate pumping device may be utilized. In some cases, the pump is coupled to a conduit, such as the coupling shown in Fig. 3 between conduit 140 and pump 150. One or more suitable pumps may be provided at any appropriate location of the system. In some embodiments, without need for a pumping device, a differential pressure gradient is provided between various regions of the system. For example, a pressure gradient may be maintained along conduit 130 so as to cause flow of sample material from the reservoir through the reservoir outlet 122 and into the process chamber via the chamber inlet 122. Similarly, a pressure gradient may also be maintained along conduit 140 which causes flow of sample material from the process chamber through the chamber outlet 114 through conduit 140 and into the reservoir via the reservoir inlet 124.

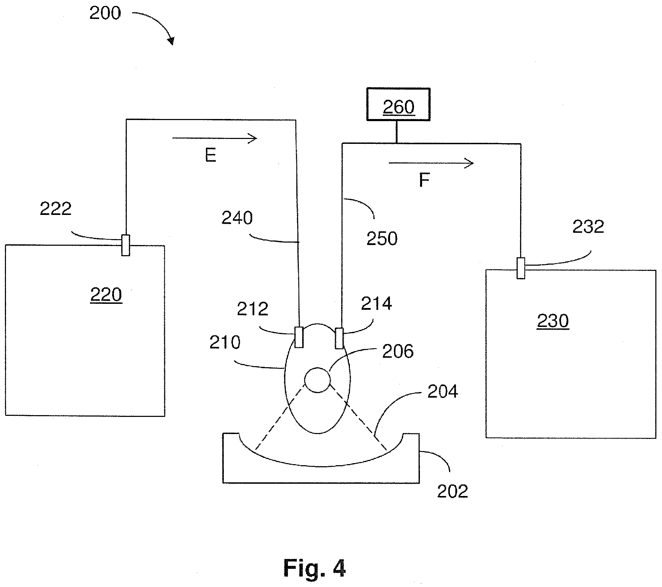

Fig. 4 shows another illustrative embodiment of a focused acoustic processing system 200 that enables large scale focused acoustic treatment of sample material. This system provides for a single pass of sample material through the process chamber. The system includes a first reservoir 220 for holding a supply of sample material to be treated, a process chamber 210 which provides a space for sample material to undergo acoustic treatment and a second reservoir 230 for receiving sample material having already been treated. The first reservoir 220 includes a reservoir outlet 222 to allow outflow of sample material from the reservoir into conduit 240 and along the direction of arrow E. The process chamber 210 includes a chamber inlet 212 for permitting inflow of the sample material into the process chamber. During treatment, acoustic transducer 202 creates acoustic waves 204 to form a suitable focal zone 206 to which the sample material is exposed. When the sample material is sufficiently treated, a suitable amount of sample material may exit from the process chamber through chamber outlet 214 and into a conduit 250 so as to travel along the direction of arrow F and into the second reservoir 230 via reservoir inlet 232. While a larger amount of sample material may be acoustically treated in this system than an amount of sample material defined simply by the volume of the process chamber, flow of sample material is not cyclical in nature, as is provided in Fig. 3. Also, besides the volume of reservoirs 220, 230, there is no limit to the amount of sample material that can be treated via flow through process chamber 210. As described above, reservoir 220 may serve as a continual source of sample material to be treated and reservoir 230 may function as a continual drain of sample material having already been treated.

Similar to that described above with respect to Fig. 3, any suitable motive force may be provided to cause the sample material to move from the first reservoir 220 to the process chamber 210 and from the process chamber to the second reservoir 230. In some embodiments, a pump 260 is provided to force the sample material to move through the focused acoustic processing system. As shown in Fig. 4, and without limitation, the pump 260 may be coupled to a conduit, for example and without limitation, conduit 250 and appropriately operated.

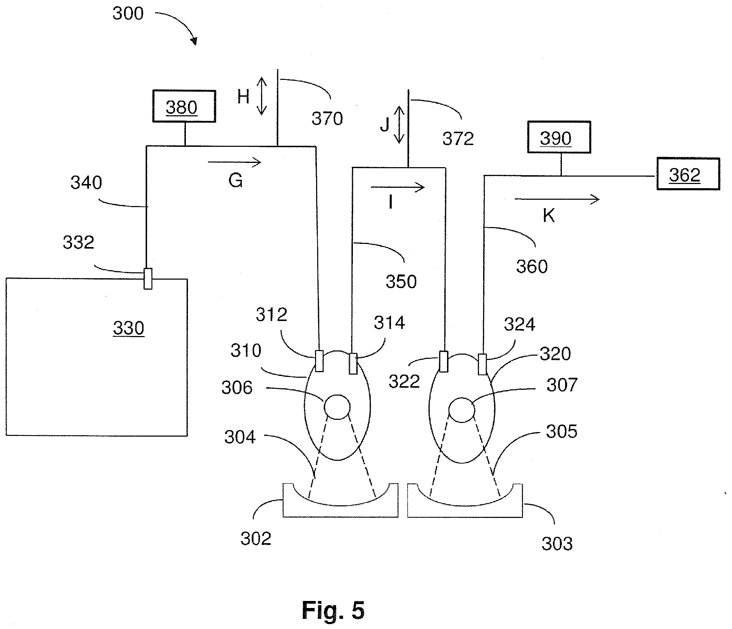

Fig. 5 depicts an illustrative embodiment of a focused acoustic processing system 300 that provides for large scale focused acoustic treatment of sample material where multiple processing chambers are employed. The system illustrated allows sample material to pass through each processing chamber where sample material may be subject to similar or different focused acoustic processing conditions. In addition, portions of sample material may be added or removed between processing chambers, as desired.

A reservoir 330 holds a supply of sample material to be treated in a first process chamber 310 and a second process chamber 320 which each provide space for sample material to undergo focused acoustic treatment. The reservoir 330 includes a reservoir outlet 332 for allowing outflow of sample material from the reservoir into conduit 340 and along the direction of arrow G. The process chamber 310 includes a chamber inlet 312 for permitting inflow of the sample material into the process chamber. During acoustic treatment, transducer 302 provides acoustic waves 304 to form an appropriate focal zone 306 to which the sample material is exposed. Upon sufficient acoustic treatment of the sample material, a suitable amount of sample material may exit from the process chamber through chamber outlet 314 and into a conduit 350. The sample material may travel along the direction of arrow I and eventually enter into the second process chamber 320 via chamber inlet 322. The sample material may undergo further acoustic treatment within the space defined by second process chamber 320 under the same or different treatment conditions as that of the first process chamber 310. The transducer 303 creates acoustic waves 305 in forming a suitable focal zone 307 which is useful for acoustic processing of the sample material. After suitable acoustic treatment, the sample material may flow out of the second process chamber 320 via chamber outlet 324 and into conduit 360 for movement along the direction of arrow K for collection at drain 362 (e.g., reservoir with limited volume, continuously drained collection of treated sample material, etc).

In some embodiments, and as shown in Fig. 5, a pump 380 is provided to provide motive force to cause movement of the sample material through the focused acoustic processing system. While the pump 380 is depicted to be coupled to conduit 340, it can be appreciated that any suitable pump may be coupled to the focused acoustic processing system at any appropriate location.

Conduits 370, 372 may be provided at appropriate locations in the system so as to allow for sample material to be added and/or removed as needed. For example, as sample material moves along conduit 340 toward first process chamber 310, conduit 370 may provide an added ingredient (e.g., a drug, carrier surfactant, co-former, solubilizer, stabilizer, etc.) to be acoustically processed in process chamber 310 along with the sample material. Similarly, conduit 372 may also remove and/or provide an additional ingredient that can be processed acoustically along with the sample material in process chamber 320. Direction arrows H, J are to illustrate that conduits 370, 372 may be utilized to add or remove material, as appropriate. It can be appreciated that any focused acoustic processing system may, as appropriate, provide certain locations where sample material may be supplemented with an additional ingredient or where a portion of sample material may be removed from the processing system.

In some embodiments, focused acoustic processing systems described herein may incorporate a suitable feedback control system for sensing characteristics of the acoustic sample treatment and adjusting parameters of the system based on the sensed characteristics. For example, certain features of the sample material may be monitored, such as for example, the level of crystallinity within the sample material, the particle size distribution of the sample material, the average particle size within the sample material, the volume of the sample material at various locations along the processing system, the rate at which sample material is moving through the system, and/or any other suitable characteristic.

For instance, after undergoing acoustic treatment through the first of two process chambers, the system may sense that the level of crystallinity in the sample material is not sufficient at that point to give rise to a stable product output. As a result, the acoustic treatment of the sample material in the second process chamber may be adjusted accordingly (e.g., the treatment could be prolonged, the cycles per burst of the focused acoustics can be adjusted, the power output from the transducer may be increased, the temperature of the next process chamber may be adjusted, etc). In another example, it may be desired that the rate of crystal growth of particles within a sample material should be above a certain amount and it is determined (e.g., by a computer or a user monitoring the rate of crystal growth within the sample) that the rate of crystal growth of particles of the sample material are below the preferred rate at that point during treatment. Accordingly, the process parameters may be adjusted accordingly to subject the sample material to an increased power/pulsed output or a prolonged treatment period resulting in a general increase in the rate of crystal growth of nanocrystalline particles within the sample material. Alternatively, it may be determined that an insufficient amount of co-former or crystal seed material is provided in the sample material for suitably forming a preferred nanocrystalline composition. As such, additional co-former may be injected into the sample material (e.g., through conduits 370, 372) or other pre-processing steps may be included so that nanocrystals may appropriately form. Other characteristics of the sample material may be monitored as well, resulting in suitable adjustments in processing parameters.

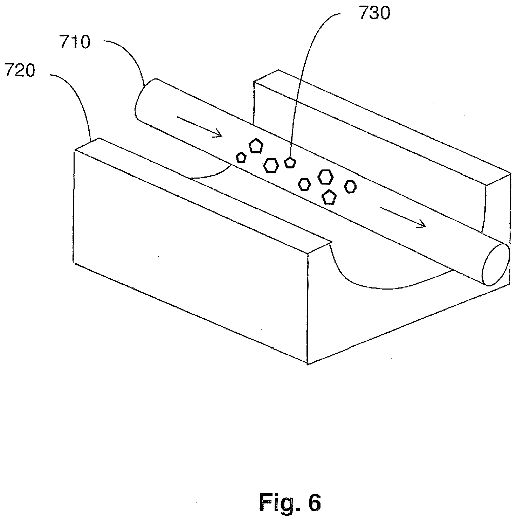

In some embodiments, methods used for preparing nanocrystalline compositions using focused acoustics may include a transducer that produces a line-shaped focal zone. Fig. 6 depicts a schematic of an illustrative embodiment of a system having an elongated process chamber 710 which is positioned such that the sample material 730 may be suitably exposed to the line-shaped focal zone as the sample flows through the process chamber. In some embodiments, the process chamber 710 may be a conduit through which the sample may flow from one region of a system vessel to another. For example, an elongated process chamber may have an aspect ratio of greater than 2, greater than 5, or greater than 10.

Line-shaped focal zones may have large aspect ratios. For example, a width of a line-shaped focal zone along the shortest size dimension of the focal zone may be less than 2 cm, less than 1 cm, or less than 1 mm. Though, a length of the line-shaped focal zone along the longest size dimension of the focal zone may be much greater than 2 cm, for example, greater than 5 cm, greater than 10 cm, greater than 20 cm, etc. In some embodiments, a line-shaped focal zone has an aspect ratio of greater than 2, greater than 5, or greater than 10. Acoustic systems suitable for producing examples of line-shaped focal zones described herein include the L-series (L8, LE220) acoustic systems produced by Covaris, Inc.

Accordingly, the sample material 730 is exposed to the focused acoustic field generated from the transducer 710 as the sample flows from one end of the elongated process chamber to another end. In some embodiments, an elongated process chamber and an acoustic transducer suitable for generating a line-shaped focal zone may be preferable in situations where the flow rate through the process chamber is high. Thus, the sample may be subject to constant exposure to the focal zone despite rapid movement through the elongated process chamber conduit. The elongated process chamber and, hence, the line-shaped focal zone may be disposed in any suitable direction, for example, vertical or horizontal, depending on the preferred direction of sample flow.

The sample may flow through the system at any suitable flow rate. In some embodiments, the flow rate of the sample through any portion of the system, including one or more process chambers may be at least 0.1 mL/min, between about 0.5 mL/min and about 100 mL/min, or between about 1 mL/min and about 10 mL/min.

Sample materials described herein may include a number of compositions, for example, in the form of a precursor to a nanocrystalline composition, or the sample material may be the nanocrystalline composition itself. In some cases, one or more of the materials within a sample or nanocrystalline composition may be any appropriate pharmaceutical, nutraceutical, cosmeceutical or combination thereof. In an embodiment, a sample material pre-treatment may include forming a solubilized amorphous drug which may or may not include a drug co-former, such as a seed material for crystallization of the drug. In some embodiments, a co-former may be included along with the active agent in forming a larger compound or arrangement where the drug crystallizes with the co-former upon exposure to a suitable amount of the focused acoustic field.

In some embodiments, a crystalline material sufficiently pure for use in pharmaceutical applications may be prepared by forming a sample including a saturated solution of the material to be crystallized, optionally adjusting the temperature of the sample so that the solution becomes supersaturated, and subjecting the sample to suitable focused acoustic energy.

Pharmaceuticals can be used as a bioactive composition in a sample and can include, but are not limited to, selective estrogen receptor modulators (SERM) (e.g., tamoxifen), alkylating agents (e.g., substituted imidazole compounds such as dacarbazine), taxane compounds (e.g., paclitaxel), a nucleoside analog (e.g., gemcitabine), a statin (e.g., lovastatin, atorvastatin, simvastatin, and the like), a pyrimidine analog (e.g., 5- fluorouracil), nucleic acid molecules (e.g., DNA, RNA, mRNA, siRNA, RNA interference molecules, plasmids, etc.), drugs/medicaments (e.g., ibuprofen, cinnarizine, indomethacin, griseofulvin, felodipine, quercetin, corticosteroids, anticholinergics, inhalable peptides/compounds, insulin, interferons, calcitonins, hormones, analgesics, codeine, fentanyl, morphine, antiallergics, antibiotics, antihistamines, anti-inflammatories, bronchodilators, adrenaline, etc.), and the like. Where appropriate, medicaments comprising active principals or drugs may be used in the form of salts (e.g. as alkali metal or amine salts or as acid addition salts) or as esters (e.g. lower alkyl esters) or as solvates (e.g. hydrates) for optimizing the activity and/or stability of the medicament. Any suitable pharmaceutical may be incorporated in nanocrystalline compostions described herein.

The sample may include any suitable composition other than a bioactive component. For example, the sample may include an appropriate organic or inorganic solvent, stabilizer or the like. The concentration of the bioactive component to be crystallized within the sample may be suitably varied. In some embodiments, the concentration of bioactive component to be crystallized within the sample is greater than 0.5% vol. or between about 1% vol. and about 10% vol.

In some embodiments, exposing the sample to the focal zone to induce nanocrystallization may include processing the sample in an isothermal environment. The focused acoustic energy applied to the sample does not have a significant degree of randomly scattered energy (i.e., in the form of heat), and so the temperature of a sample material may, in general, be maintained within a suitable degree of variation. For example, the temperature of the sample may be maintained at a temperature within about 5 degrees C, within about 2 degrees C, or within about 1 degree C of a starting temperature.

Nanocrystalline compositions prepared in accordance with methods described herein may have any suitable particle size distribution. Although not required, in some embodiments, systems and methods described that involve the use of focused acoustic energy to prepare nanocrystalline compositions result in a particle size distribution that is unimodal. For example, the particle size distribution may be similar to a Gaussian distribution. However, in other cases, the particle size distribution of suitable nanocrystalline compositions is multi-modal. In some embodiments, the PDI of particle size distributions of acoustically treated nanocrystalline compositions is less than 0.5, less than 0.3, less than 0.1, less than 0.08, or less than 0.06. For example, the PDI of particle size distributions of suitably acoustically treated nanocrystalline compositions may be between about 0.03 and about 0.1, between about 0.05 and about 0.09, or between about 0.06 and about 0.08. In some embodiments, the relative standard deviation of the particle size distribution of an acoustically treated nanocrystalline composition may be less than 1%, less than 0.5%, or between 0.1% and 0.8% of an average particle size of the nanocrystalline composition.

Nanocrystalline compositions prepared with systems and methods employing focused acoustics described herein may exhibit a long shelf life without sample degradation (i.e., maintaining functionality). In some embodiments, the processed material may be almost entirely crystalline (i.e., little to no amorphous particles). As an indication of the crystallinity of a nanocrystalline composition, after a certain period of time (e.g., after an hour), the particle size distribution of the nanocrystalline composition may be generally stable. That is, there is minimal tendency for small crystalline particles of the nanocrystalline composition to coalesce into larger particles over time. Amorphous particles, in contrast, may exhibit a greater tendency to combine together into large-sized particles.

In some embodiments, upon allowing a preferred nanocrystalline composition to stand for 12 hours, 24 hours, 2 days, 5 days, 1 week, 1 month, 1 year, or longer, the average particle size and/or polydispersity index of embodiments of the nanoformulation fluctuates by no more than 2%, 5% or less than 10%. In some embodiments, the desired size distribution of particles formed in a nanocrystalline composition (e.g., 100 nm, 1 micron, 10 microns, 50 microns, having a low PDI, etc.) may be maintained over a prolonged period of time, such as for example, between 1 day and 24 months, between 2 weeks and 12 months, or between 2 months and 5 months.

Focused acoustics can be used to enhance efficiency and impart a large degree of convenience to the preparation of nanocrystalline compositions. In some embodiments, the time of exposure of a sample to a focused acoustic field resulting in a suitable nanocrystalline composition is short. For example, a sample may be exposed to a focused acoustic field to form a suitable nanocrystalline composition for a time period of less than less than 5 hours, less than 1 hour, less than 30 minutes, less than 10 minutes, or less than 5 minutes.

Systems and methods of using focused acoustics to encourage nanocrystalline formation in accordance with aspects presented may involve suitably varying the cycles per burst of the focused acoustic field, or the number of acoustic oscillations contained in each burst. In some embodiments, the cycles per burst may change between 1000 cycles per burst and 6000 cycles per burst. For example, in some cases, the rate of nucleation and crystal growth of a sample may increase upon increasing the cycles per burst. In an embodiment, the processing time for sample crystallization at 200 cycles per burst may be about 50 minutes; though, upon increasing the cycles per burst to 5000, the processing time was reduced to 5 minutes. In various embodiments, an acoustic transducer is operated to generate a focused acoustic field having greater than 1000 cycles per burst, greater than 2000 cycles per burst, greater than 3000 cycles per burst, greater than 4000 cycles per burst, greater than 5000 cycles per burst, or greater than 6000 cycles per burst. In some cases, a focused acoustic field generated with a greater amount of cycles per burst may provide for production of a stable nanocrystalline composition with a tight particle size distribution. In some embodiments, a change in the cycles per burst might not substantially affect the overall processing time for the sample to be stably crystallized.

Focused acoustic systems may operate at any suitable power for preparing nanocrystalline compositions having preferred characteristics. In some embodiments, a focused acoustic field is operated at a power of between 50 Watts and 300 Watts, between 100 Watts and 250 Watts, between 50 Watts and 150 Watts, or between 200 Watts and 300 Watts.

### EXAMPLES

The following examples are intended to illustrate certain embodiments of the present invention, but are not to be construed as limiting and do not exemplify the full scope of the invention.

### Example 1

Crystalline nanoparticles were formed using a 2 mL sample that initially included 1 part DMA, 99 parts PVP/SDS stabilizer and Felodipine. The sample was processed using a Covaris S220 machine, using a water bath temperature of 18 degrees C, a 50% duty cycle, 75 watts peak incident power (PIP), 1000 cycles/burst and a total treatment time of 20 minutes.

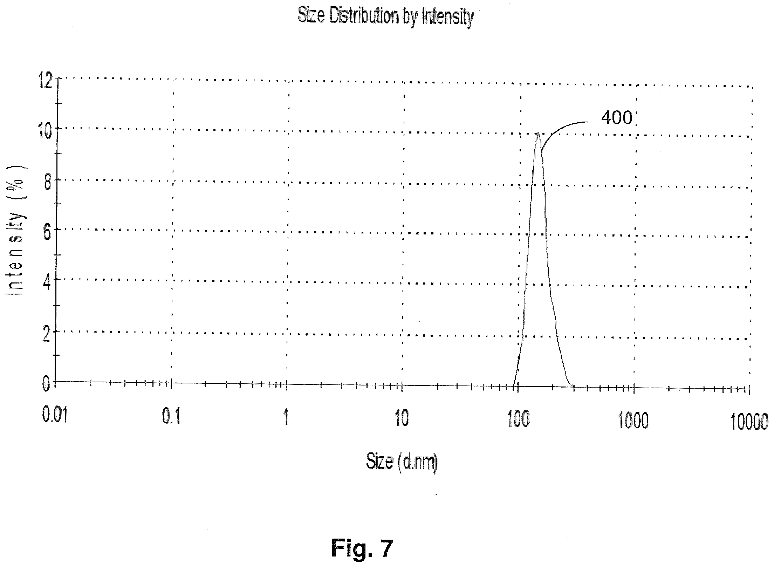

This processing resulted in the formation (growth) of crystalline nanoparticles in which 100% of the particles were part of a unimodal distribution having an average size of about 154.6 nm with a mode of 153.2. A narrow size range of particles was produced, with the PDI measured to be 0.136. Fig. 7 depicts the particle size distribution 400 of the nanocrystalline composition.

### Example 2

A 18 mL sample of crystalline nanoparticles was prepared initially including 1 part DMA, 99 parts PVP/SDS stabilizer and Felodipine. The sample was processed using a Covaris S220 machine, using a water bath temperature of 15 degrees C with a total treatment time of 5 minutes. The focused acoustic system was operated at 5000 cycles per burst. In a comparative example where the focused acoustic system was operated at 200 cycles per burst, the total treatment time for full crystalline formation was 50 minutes; in contrast to the current example where full crystalline formation occurred in a processing time of 5 minutes at 5000 cycles per burst.

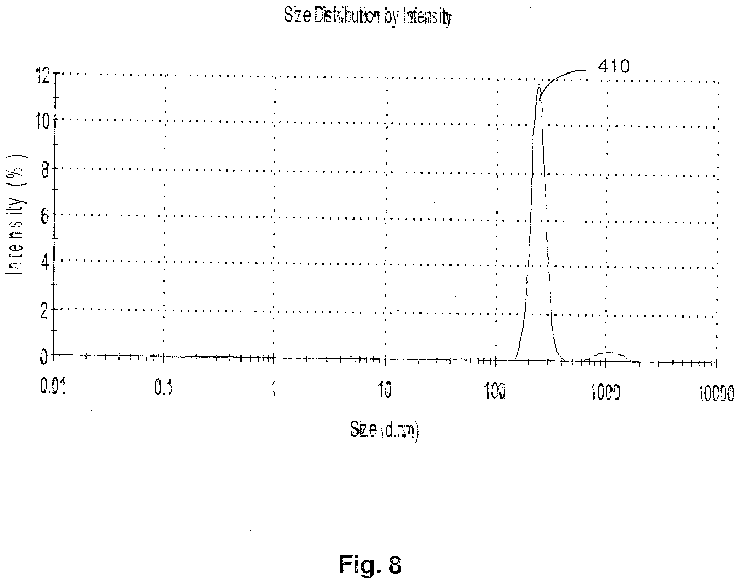

This example resulted in the crystal growth formation of crystalline nanoparticles having a bimodal distribution with a dominant peak and an average particle size of 257.3 immediately after processing. Fig. 8 shows the particle size distribution 410 immediately after processing which includes 94.4% of the particles having a mode of 244.4 nm and 5.6% of the particles having a mode of 1,083 nm. The PDI was measured to be 0.138.

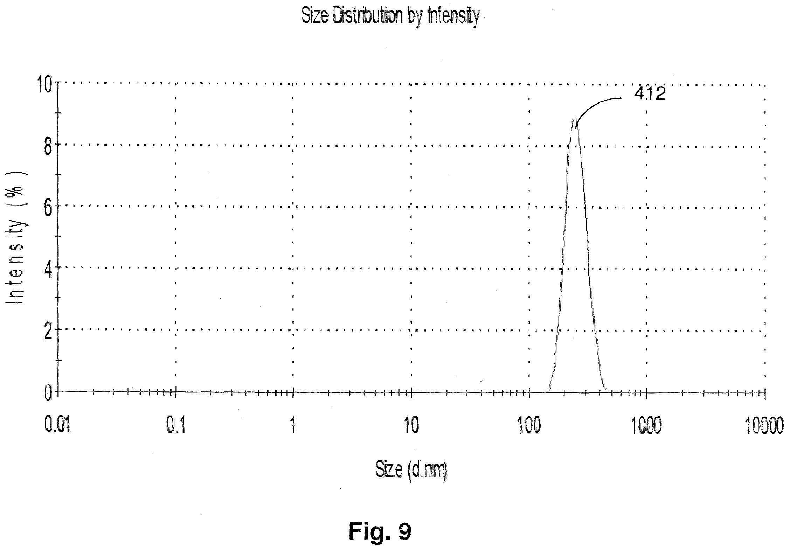

The processed sample was then allowed to stand for 4 hours. Fig. 9 depicts the particle size distribution 412 after this time period. The resulting average particle size was 246.3 nm and the mode of 100% of the particles was 257.1 nm. The PDI was measured to be 0.090.

### Example 3

A 100 mL sample of crystalline nanoparticles was prepared using a similar sample mixture as that of Examples 1 and 2. However, a multi-pass system similar to that shown in Fig. 3 was implemented so that a large volume of sample would be processed cyclically for 10 minutes. The flow rate was 10 mL/min.

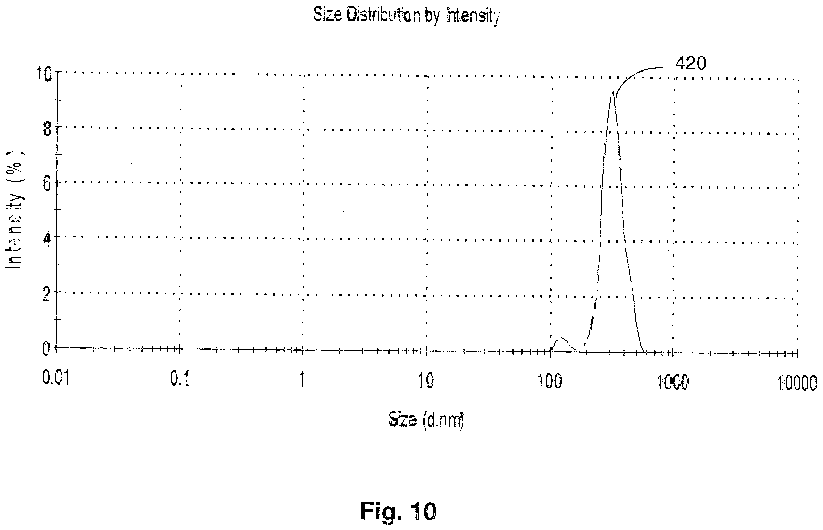

The above processing resulted in the crystal growth formation of crystalline nanoparticles having a bimodal distribution with a dominant peak and an average particle size of 306.0 immediately after processing. Fig. 10 shows the particle size distribution 420 immediately after processing which includes 97.1% of the particles having a mode of 327.7 nm and 2.9% of the particles having a mode of 125.1 nm. The PDI was measured to be 0.087.

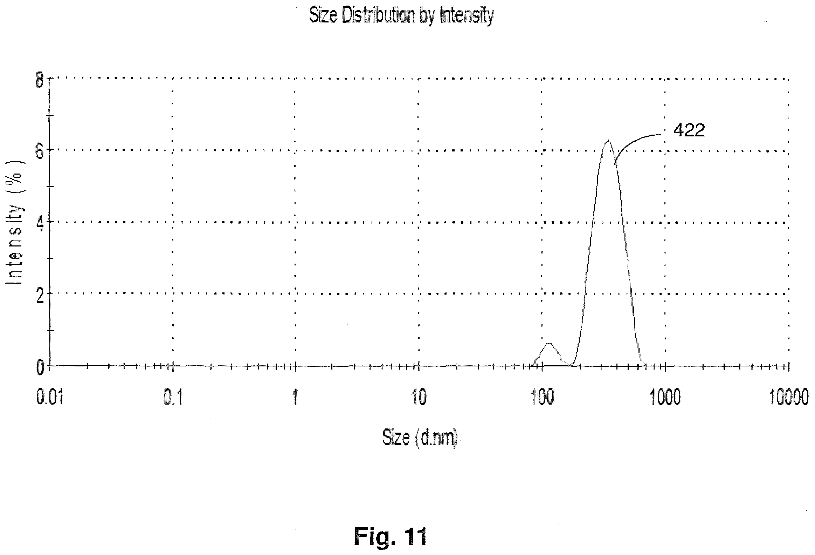

The processed sample was then allowed to stand for 4 hours. Fig. 11 depicts the particle size distribution 422 after this time period. The resulting average particle size was 301.5 nm. The mode of 95.3% of the particles was 257.1 nm and the mode of 4.7% of the particles was 115.2. The PDI was measured to be 0.129.

### Example 4

A 100 mL sample of crystalline nanoparticles was prepared employing a similar sample mixture and multipass system as that of Example 3 above. The multi-pass system allowed for a large volume of sample to be processed cyclically for 20 minutes. The flow rate was 5 mL/min.

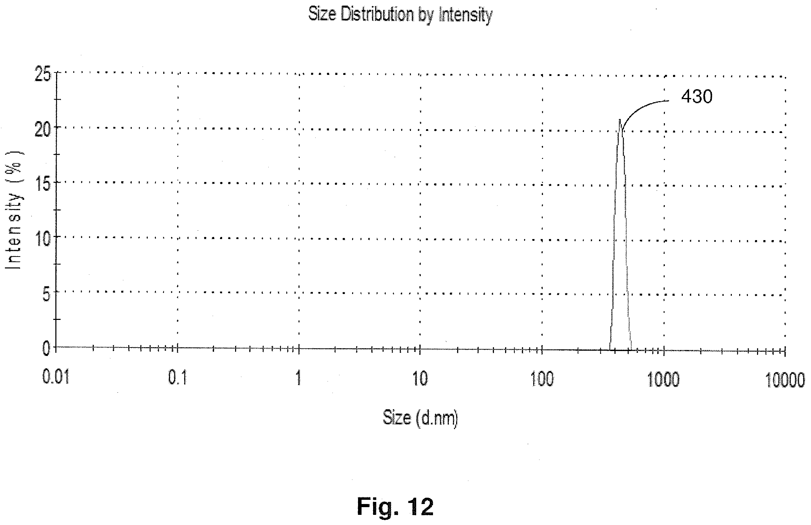

The above processing resulted in the crystal growth formation of crystalline nanoparticles having a unimodal distribution having an average particle size of 441.0 about 2 hours after processing. Fig. 12 depicts the particle size distribution 430 which shows 100.0% of the particles having a mode of 439.7 nm. The PDI was measured to be 0.048.

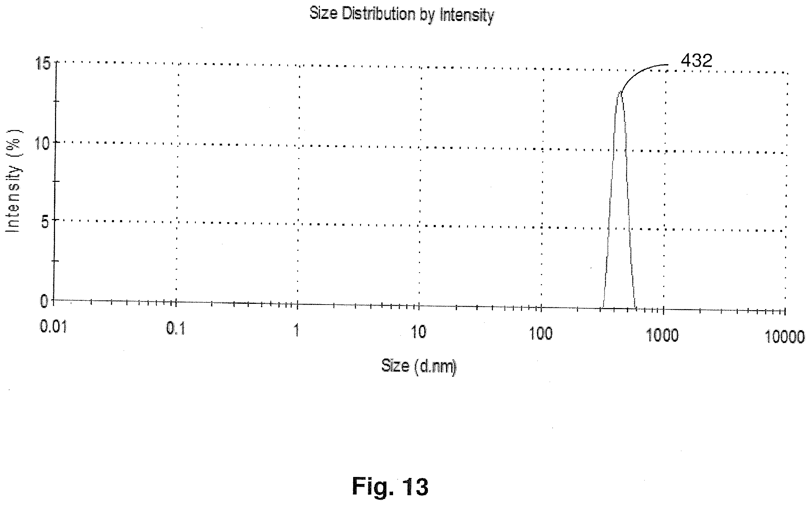

The processed sample was allowed to stand providing for 72 hours of shelf time. Fig. 13 depicts the particle size distribution 432 72 hours after processing. The resulting average particle size was 433.2 nm. The mode of 100.0% of the particles was 432.9 nm. The PDI was measured to be 0.097.

### Example 5

A 100 mL sample of crystalline nanoparticles was prepared using a similar sample mixture as the above Examples. A single-pass system similar to that shown in Fig. 4 was employed allowing for a large volume of sample to be processed for 10 minutes. The flow rate was 5 mL/min.

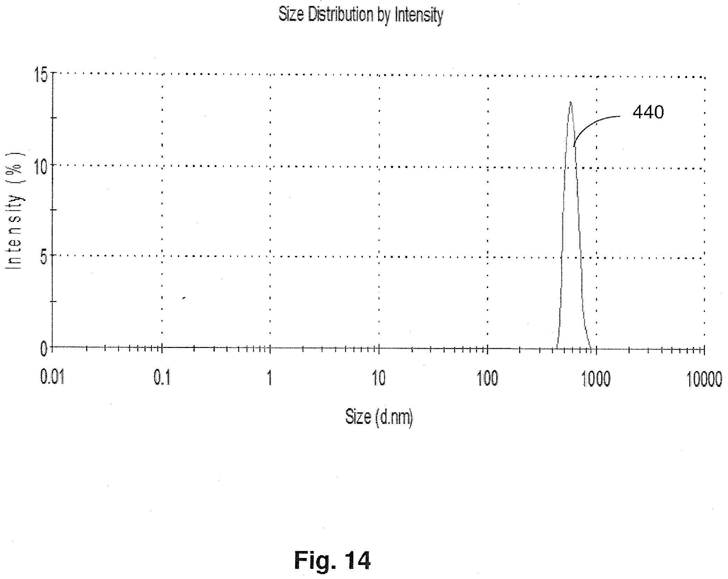

This processing resulted in the crystal growth formation of crystalline nanoparticles having a unimodal distribution having an average particle size of 592.3 immediately after processing. Fig. 14 depicts the particle size distribution 440 which shows 100.0% of the particles having a mode of 577.0 nm. The PDI was measured to be 0.123.

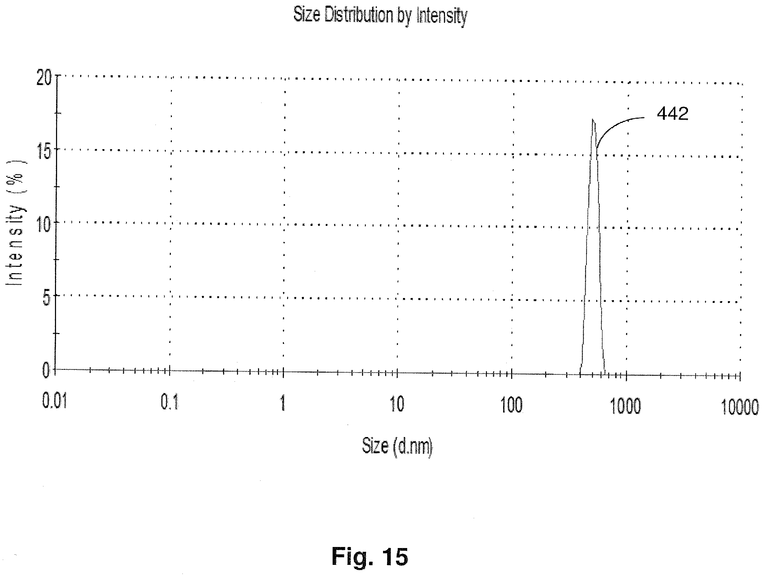

The processed sample was allowed to stand for 2 hours. Fig. 15 depicts the particle size distribution 442 2 hours after processing. The resulting average particle size was 546.4 nm. The mode of 100.0% of the particles was 510.8 nm. The PDI was measured to be 0.158.

### FURTHER EMBODIMENTS

Other embodiments described below relate to the usage of focused acoustics for treating material that flows past or through a processing zone and may be employed in suitable combination with aspects including the reproducible formation of large volumes of nanocrystalline particles through crystal growth, presented herein.

Systems and methods relate to scaling a process utilizing focused acoustical energy to larger volume batch and continuous process flows, such that the desired result of acoustic treatment can be achieved on larger sample volumes. The desired result of acoustic treatment, which may be achieved or enhanced by use of ultrasonic wavetrains, can be without limitation, causing crystal growth in the sample (i.e., creating nucleation sites and/or augmenting crystal growth), heating the sample, cooling the sample, fluidizing the sample, micronizing the sample, mixing the sample, stirring the sample, disrupting the sample, permeabilizing a component of the sample, forming a nanoemulsion or nano formulation, enhancing a reaction in the sample, solubilizing, sterilizing the sample, lysing, extracting, comminuting, catalyzing, and selectively degrading at least a portion of a sample. Sonic waves may also enhance filtration, fluid flow in conduits, and fluidization of suspensions. Processes of the present disclosure may be synthetic, analytic, or simply facilitative of other processes such as stirring.

For example, altering the permeability or accessibility of a material in a controlled manner can allow for manipulation of the material while preserving the viability and/or biological activity of the material. In another example, mixing materials or modulating transport of a component into or out of materials, in a reproducible, uniform, and automated manner, can be beneficial. According to one embodiment of the system, sample processing control includes a feedback loop for regulating at least one of sonic energy location, pulse pattern, pulse intensity, duration, and absorbed dose of the ultrasound to achieve the desired result of acoustic treatment. In one embodiment, the ultrasonic energy is in the megahertz (MHz) frequency range, in contrast to classical sonic processing which typically employs ultrasonic energy in the kilohertz (kHz) frequency range.

In prior systems, when unfocused, and uncontrolled ultrasonic energy interacts with a complex biological or chemical system, the acoustic field often becomes distorted, reflected, and defocused. The net effect is that energy distribution becomes non-uniform and/or defocused compared to the input. Non-uniform reaction conditions can limit reaction applications to noncritical processes, such as bulk fluid treatment where temperature gradients within a sample are inconsequential. However, some of the non-uniform aspects are highly deleterious to samples, such as extreme temperature gradients that damage sample integrity. For example, in some instances, high temperatures generated would irreversibly denature target proteins. As another example, when improperly controlled ultrasound is applied to a bulk biological sample solution, such as for the extraction of intracellular constituents from tissue, the treatment causes a complex, heterogeneous, mixture of sub-events that vary during the course of a treatment dose. For example, the energy may spatially displace a target moiety and shift the target out of the optimal energy zone. Additionally or alternatively, the energy may result in interference that reflects the acoustic energy. For example, a "bubble shield" occurs when a wave front of sonic energy creates cavitation bubbles that persist until the next wave front arrives, such that the energy of the second wave front is at least partially blocked and/or reflected by the bubbles. Still further, larger particles in the sample may move to low energy nodes, thereby leaving the smaller particles in the sample with more dwell-time in the high energy nodes. In addition, the sample viscosity, temperature, and uniformity may vary during the ultrasonic process, resulting in gradients of these parameters during processing. Accordingly, current processes are generally random and non-uniform, especially when applied to in vitro applications, such as membrane permeabilization, hindering the use of ultrasound in high throughput applications where treatment standardization from one sample to the next is required. As a consequence, many potential applications of ultrasound, especially biological applications, are limited to specific, highly specialized applications, such as lithotripsy and diagnostic imaging, because of the potentially undesirable and uncontrollable aspects of ultrasound in complex systems.

The use of focused acoustical energy, as described in U.S. Patent 7,521,023 (which is incorporated herein by reference in its entirety) and others, can overcome these limitations, and methods for acoustic treatment of a sample in an enclosed vessel are disclosed. Processing of sample material volumes greater than that of a single vessel can be achieved by transfer of the material into, and out of a focused acoustical 'process zone' or 'reaction chamber'. The material may be resident in the processing zone until the desired result is achieved (single pass), and then transferred to downstream process steps, or captured as a finished product.

Aspects of the present invention addresses the problem of scaling the application of focused ultrasonic energy to treat larger volumes of material, including continuous processes as well as batch scale processing, and provides apparatus and methods for the non-contact treatment of samples with ultrasonic energy using a focused beam of energy. The frequency of the beam can be variable, can be in the range of about 100 kHz to 100 MHz, more preferably 500 kHz to 10 MHz, and can be focused to a processing zone of approximately 10mm to 20mm (and possibly of larger size with increases in energy), with the sample material passing through this zone to achieve the desired effect. For example, some embodiments of the present invention can treat samples with ultrasonic energy while controlling the temperature of the sample, by use of computer-generated complex wave trains, which may further be controlled by the use of feedback from a sensor. The acoustic output signal, or wave train, can vary in any or all of frequency, intensity, duty cycle, burst pattern, and pulse shape. Moreover, this treatment can be undertaken automatically under computer control, and can also be linked to instrumentation and measurement feedback from the bulk or output stream. In another example, some embodiments of the present invention can treat samples with ultrasonic energy by relative movement of the sample and the focus of the beam, in any or all of two or three dimensions, to ensure complete and thorough mixing within the processing zone.

In some embodiments, material can be processed in a chamber that is sealed and has one or more inlets and outlets to the chamber for effective transfer of the bulk fluid material through the chamber. The chamber can be sealed during the treatment to prevent contamination of the sample material or of the environment. In some embodiments, arrays of chambers can be used for processing multiple sample streams in parallel, where very large sample volumes are needed, such as in manufacturing process streams. In some embodiments, the chambers and/or other components that contact a material processed may be made in a disposable form, e.g., for one time use in processing a material and discarded thereafter.

The sample container can be a chamber comprised of one or more pieces and may include an acoustic 'window' through which the sonic energy passes. This window can be made from a variety of materials to optimize the desired effect, and can include glass, thin film polymers such as polyimide, other moldable polymers, quartz, sapphire and other materials. The chamber can have one or more inlets and one or more outlets for transfer of material into or out of the chamber. The rate at which material is transferred through the chamber can be controlled actively via a pumping system, such as a peristaltic, gear, or other pump, or passively via gravity fed methods such as elevation changes or tilting a chamber through an oscillation about its axis. The apparatus can also include an acoustically transparent material disposed between the sonic energy source and the holder. The sonic energy source can generate sonic energy at two or more different frequencies, optionally in the form of a serial wavetrain. The wavetrain can include a first wave component and a different second wave component. Alternatively or additionally, the wavetrain can include about 1000 cycles per burst at about a 10% duty cycle at about a 500 mV amplitude.

In one illustrative embodiment, a system for treating a material with acoustic energy includes a chamber defining an internal volume and having an opening into the internal volume. An inlet is arranged to provide an inflow of material into the internal volume and an outlet is arranged to discharge an outflow of material from the internal volume. In some arrangements, the inlet and/or outlet may be have a check valve or otherwise be arranged to help influence flow in the internal volume, e.g., help ensure that flow, though potentially intermittent, is maintained in a direction from the inlet to the outlet. A window in the opening of the chamber may be arranged to sealingly close the opening and to transmit focused acoustic energy into the chamber for treatment of material in the internal volume. The window may be generally transparent to acoustic energy having a frequency of about 100 kHz to 100 MHz. In this way, the window may minimally impede the acoustic energy traveling into the internal volume. In some arrangements, the window may help direct the acoustic energy, e.g., the window may have a convex face or other arrangement that has a focusing or lens effect on the acoustic energy. An acoustic energy source, such as one or more piezoelectric transducers, may be spaced from the window and be arranged to emit acoustic energy having a frequency of about 100 kHz to 100 MHz so as to create a focal zone of acoustic energy in the internal volume. The system may be arranged to accommodate continuous acoustic treatment of material in the chamber for an extended time period, e.g., for 1 hour or more, at a relatively high intensity, e.g., at an output of the acoustic transducer of 200 watts or more, without experiencing excessive heat buildup or other problems. (In a continuous acoustic treatment, material may be caused to flow in a continuous fashion in a chamber, or may flow in an intermittent fashion. Also, the acoustic energy source may operate at a power level that varies, but on a time averaged basis operates at a relatively high power output level, e.g., 200 watts or more) This is in contrast to prior acoustic treatment arrangements in which continuous acoustic treatment for 1 hour or more could not have been achieved for a variety of different reasons, such as excessive heat buildup, failure of the acoustic source, damage to the sample material, and so on.

In some arrangements, the internal volume may be suitably sized or otherwise arranged to help expose material in the internal volume to the acoustic energy. For example, the internal volume may include walls that are located near the boundaries of an acoustic focal zone in the internal chamber to help ensure that material is maintained in or near the focal zone during treatment. In other arrangements, the internal volume may include elements that provide nucleation points for cavitation or other acoustically-caused affects. A coupling medium, which may be liquid or solid, may be arranged to transmit acoustic energy from the acoustic energy source to the window. For example, a water bath may be positioned between the acoustic energy source and the window of the chamber. In some arrangements, the chamber may be partially or completely submerged in a liquid coupling medium, such as water.

In one illustrative embodiment, the chamber and window may be arranged to maintain a pressurized environment in the internal volume. Providing a suitable pressure in the internal volume may help enhance reaction rates, may help reduce cavitation, or provide other desirable affects in the acoustic treatment. The chamber may include a second window, e.g., on an upper surface of the chamber opposite the window, that permits visual inspection of the internal chamber. For example, a sensor, such as a video camera or other optical sensor, may capture images of the internal chamber during treatment. The image data may be used to control operation of the system, such as material flow rates, acoustic energy properties, etc., to achieve desired results. For example, image analysis techniques may be used on the image data to detect treatment characteristics, such as cavitation bubble presence or size, material flow rates, mixing rates, etc., and/or material characteristics, such as particle size, homogenization, fluidization, etc., which are used to control the acoustic source or other aspects of the system.

In one embodiment, the chamber may include a heat exchanger at an outer surface arranged to exchange heat with the coupling medium. For example, the heat exchanger may include a plurality of radial fins, rods, recesses, cavities or other features that help to transfer heat with respect to the internal volume of the chamber. In some arrangements, heat may be transferred into the internal volume, whereas in other arrangements, heat may be transferred out of the internal volume, at least in part, by the heat exchanger. A temperature of a coupling medium, whether the acoustic coupling medium or other thermal coupling medium, may be controlled to affect desired heat transfer. An electric resistance heater or other heat generator may be provided with the chamber to provide an additional heat source, if desired. In another embodiment, the heat exchanger may include a heating or cooling jacket associated with at least a portion of the chamber to deliver heating/cooling fluid to a wall of the chamber. The jacket may allow a thermal coupling medium to contact the chamber while also keeping the thermal coupling medium separate from an acoustic coupling medium. This arrangement may useful, for example, where a particular type of material (such as water) is best used for acoustic coupling, while a different material (such as an antifreeze solution) is best used for thermal coupling.

In one illustrative embodiment, the chamber may have a barrel shape, and the inlet and outlet may each include a conduit that extends away from the chamber along a longitudinal axis of the barrel shape. Thus, the chamber may, in some sense, depend from the inlet and outlet or otherwise be positioned below the inlet and outlet conduits. The chamber may be used with a vessel that has an internal volume and an opening through which the chamber may be passed so as to be positioned in the vessel. The acoustic energy source may also be located in the vessel along with a coupling medium. A cap may be arranged to close the opening of the vessel, e.g., so as to enclose the chamber in the vessel. The inlet and outlet may each include a conduit that extends away from the chamber and passes through the cap so that material may be introduced into the chamber even though the vessel may be otherwise completely sealed from an external environment.

In another illustrative embodiment, the chamber may include an insert element that defines, at least in part, a shape and size of the internal volume. The insert element, which may include two or more separate parts or a single component, may be provided in the chamber to serve any one of several functions, such as providing a plurality of nucleation sites for cavitation, providing catalyst or other sites for enhancing reactions, defining the internal volume to have a particular shape, size or other configuration, helping to transfer heat into/out of the internal volume, and so on. For example, the insert element may define the internal volume to have a size and shape that closely matches or otherwise interacts with a focal zone of acoustic energy in the chamber. The insert element may be made of any suitable material, such as a ceramic material, may include components of any suitable size or shape, such as a plurality of rod members, or have other desired features.

In another aspect of the invention, a system for acoustically treating a material includes a chamber defining an internal volume and having an inlet to provide an inflow of material into the internal volume and an outlet to discharge an outflow of material from the internal volume. An acoustic energy source may be spaced from the chamber and arranged to emit acoustic energy having a frequency of about 100 kHz to 100 MHz to create a focal zone of acoustic energy in the internal volume, e.g., for treating material in the internal volume. A coupling medium, which may be liquid or solid, may be arranged to transmit acoustic energy from the acoustic energy source to the chamber. A reservoir may contain a material to be treated by acoustic energy in the chamber, and an agitator may be arranged to mix or otherwise move the material within the reservoir. A supply conduit fluidly connected between the reservoir and the inlet of the chamber may deliver material from the reservoir to the chamber, and a return conduit fluidly connected between the reservoir and the outlet of the chamber may return material to the reservoir. In some embodiments, a pump may be arranged to cause the material to flow through the supply and return conduits, and a second reservoir may be provided that optionally receives material from the return conduit. For example, the return conduit may include a three-way valve or other arrangement that allows material to be directed to the second reservoir rather than be returned to the first reservoir.

In another aspect of the invention, a system for acoustically treating a material includes a chamber defining an internal volume and having an inlet to provide an inflow of material into the internal volume and an outlet to discharge an outflow of material from the internal volume. An acoustic energy source may be spaced from the chamber and arranged to emit acoustic energy having a frequency of about 100 kHz to 100 MHz to create a focal zone of acoustic energy in the internal volume, e.g., to treat the material in the chamber. A coupling medium may be arranged to transmit acoustic energy from the acoustic energy source to the chamber. A first conduit may be fluidly connected to the inlet of the chamber, and a second conduit may be fluidly connected to the outlet of the chamber so that material in the conduits is caused to flow in a first direction from the first conduit through the internal volume and into the second conduit, and subsequently to flow in a second direction from the second conduit through the internal volume and into the first conduit. Flow of the material may be caused by a pump, gravity or other motive force, and the first and/or second conduits may be connected to a respective reservoir that serves to hold material as necessary.

In another aspect of the invention, a system for acoustically treating a material may include first and second acoustic treatment assemblies that are arranged in series. That is, material may be treated in a first chamber, and then delivered for subsequent treatment in a second chamber. Each of the treatment assemblies may include a chamber defining an internal volume and having an inlet to receive an inflow of material into the internal volume and an outlet to discharge an outflow of material from the internal volume, an acoustic energy source spaced from the chamber and arranged to emit acoustic energy having a frequency of about 100 kHz to 100 MHz to create a focal zone of acoustic energy in the internal volume, and a coupling medium arranged to transmit acoustic energy from the acoustic energy source to the chamber. A reservoir may be arranged to contain a material to be treated by acoustic energy in the chambers of the first and second acoustic treatment assemblies, and a supply conduit may be fluidly connected between the reservoir and the inlet of the first treatment assembly. A transfer conduit may be fluidly connected between the outlet of the first treatment assembly and the inlet of the second treatment assembly, e.g., to transfer material from the first chamber to the second chamber.

### Apparatus and Methods for Ultrasonic Treatment

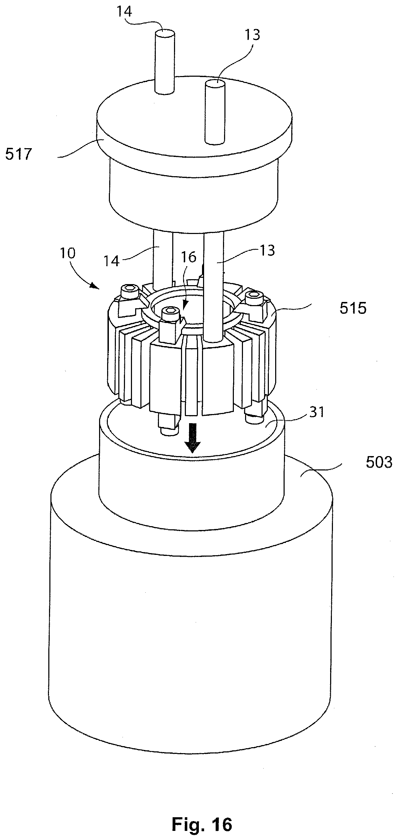

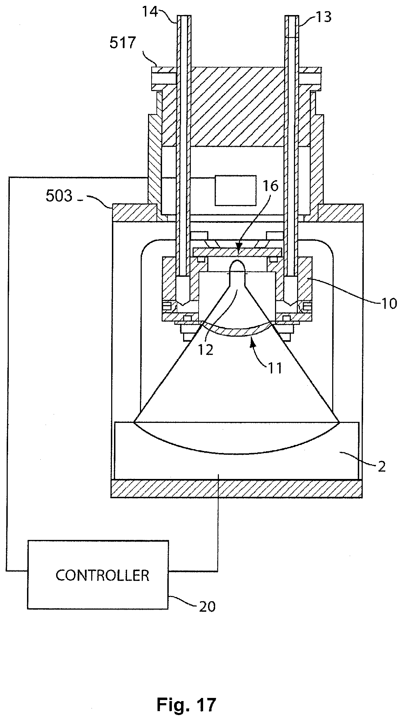

FIGs. 16 and 17 depict one embodiment of a processing chamber 10, where focused acoustic energy generated by an acoustic energy source 2 passes through an acoustic window 11 of the chamber and into an internal volume 12 of the chamber 10 where the sample material is located. As is discussed in more detail below, the acoustic treatment system 1 may include a controller 20 (e.g., including a suitably programmed general purpose computer or other data processing device) that receives control information (e.g., from one or more sensors, user input devices, etc.) and correspondingly controls operation of the acoustic energy source 2 and/or other system components. Sample material is provided into the internal volume 12 via an inlet 13 and is removed from the volume 12 via an outlet 14. The inlet and outlet may be arranged in a variety of ways, and in this embodiment the inlet 13 and outlet 14 each include a conduit coupled to the chamber 10. In some embodiments, the inlet and/or outlet may include a check valve, one-way valve, electronically-controlled valves or other arrangement that helps to ensure that flow occurs in a desired way, e.g., so the flow of material is always from the inlet to the outlet even though flow may be intermittent. The internal volume 12 may be sized and shaped as appropriate for the material to be treated, e.g., some acoustic treatment applications (such as sterilization) may function more effectively if a relatively small volume of material is treated in a relatively small volume, whereas other applications (such as mixing) may produce better results using a larger volume for the internal volume 12. The internal volume 12 can have different shapes or other configuration characteristics, e.g., the internal volume 12 may be defined by vertical walls, can have a conical shape, can have a curved shape, and so on. Also, the chamber 10 can be made of multiple components such as an upper member, lower acoustically transparent member, and a body which together define the internal volume that contains the material to be treated. Alternately, the chamber 10 may be made as a single unitary piece or in other ways.

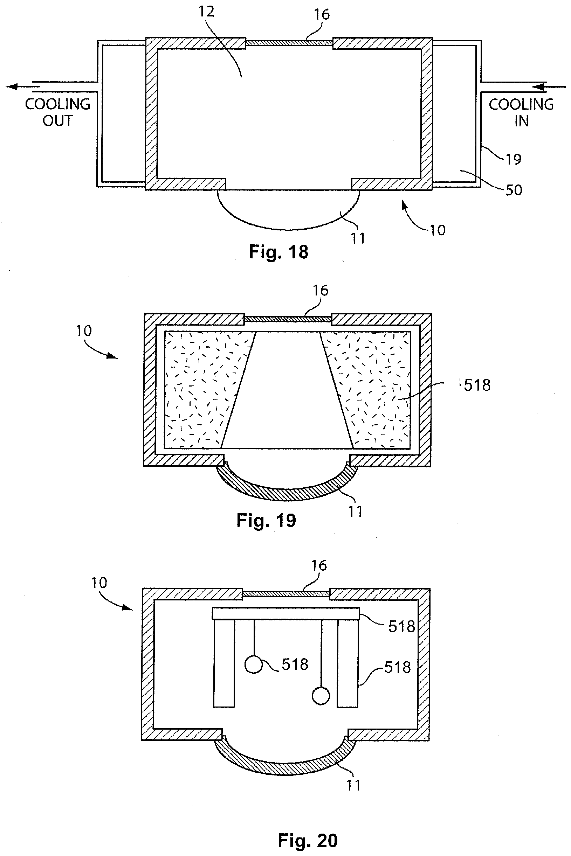

One or more walls of the chamber 10 may serve as, or otherwise be associated with, a thermal transfer mechanism, or heat exchanger, to dissipate any heat generated in the internal volume512 and/or to receive heat from outside of the chamber 10 that is transferred into the internal volume 12. As can be seen in FIG. 16, the chamber 10 may include a heat exchanger 515 in the form of a plurality of radial fins. Of course, the heat exchanger 515 could be formed in other ways, such as including a Peltier device that uses electrical power to transfer heat from one location to another, an electric resistance heater, heat conducting rods, tubes or other structures, phase-changing materials used to transfer heat from one location to another, and so on. The heat exchanger 515 may be arranged to operate with any suitable thermal coupling medium, such as air or other gas, water or other liquid, or a solid material. For example, as shown in FIG. 17, the chamber 10 may be completely or partially submerged in a liquid that serves to transmit heat with respect to the heat exchanger 515. Close thermal coupling between water or other outside thermal coupling medium and the internal volume 12 may help control of the temperature of the material in the internal volume 12 during acoustic processing. Control of the temperature of the coupling medium 4 can help control temperature in the internal volume 12. For example, the coupling medium 4 can be recirculated through a chiller, a heater, or other means to adjust the temperature of the coupling medium 4. Thus, the sample material inside the chamber 10 can be thermally linked to the coupling medium 4 temperature by careful consideration of the design of the chamber 10. The thermal coupling between the inside wall of the chamber 10 and the sample material may be tightly linked, due to high mixing, turbulence, and activity/or at the surface of the internal wall, thus creating high convective heat transfer. Heat can pass either through one or more ends of the chamber 10 (e.g., at the windows 11 and 16), or through the side walls of the vessel before being linked to the coupling medium 4 bulk temperature. Note that heat can flow in either direction, depending on the relative difference between the coupling medium and the sample material temperature, and the desired target of maintaining the sample at a target temperature to achieve the desired effect. The transfer between the chamber 10 internal wall and the coupling medium can be achieved by simple conduction through the wall to the outside surface, or the external surface area can be enhanced through the use of fins or other high heat transfer effects such as a jacketed vessel with pumped fluid. For example, FIG. 18 shows an illustrative arrangement in which a jacket 19 is positioned around at least part of the chamber 10 and a thermal transfer medium 50 is circulated in the space between the jacket 19 and the chamber 10 external wall. In addition, the inlet and/or outlet conduits can also be coupled to the coupling medium temperature and/or the thermal transfer medium by the use of enhanced thermal surfaces at the inlet, or outlet of the chamber 10. For example, although not shown in FIG. 18, the inlet 13 and/or outlet 14 may pass through the space between the jacket 19 and the chamber 10 so as to transfer heat with respect to the thermal transfer medium 50. Alternately, the inlet and/or outlet medium conduit may include heat exchanger features that allow heat to be transferred with respect to the acoustic coupling medium 4.

In certain embodiments, the acoustic energy source 2 may include an ultrasound transducer that projects a focused ultrasound beam or wave front toward the window 11 of the chamber 10. The window 11, which may sealingly close an opening in the chamber 10, may be suitably transparent to, or otherwise transmit acoustic energy so that the ultrasound beam penetrates the window 11 to form a focal zone within the internal volume 12 that acts upon the material in the chamber 10. The window 11 may be configured to transmit a maximum amount of ultrasound energy to the material in the chamber 10, minimize the absorption of ultrasound energy within the walls of the chamber 10, and/or maximize heat transfer between the internal volume 12 and, for example, an external water bath or other coupling medium. In certain embodiments, the window 11 is glass, sapphire, quartz or a polymer such as a thin film polymer. The window may have any suitable shape or other configuration, e.g., may be flat (or otherwise present a relatively flat surface to the impinging acoustic energy), or may be curved so as have a hemispherical or other convex shape. In certain embodiments, the window 11 is shaped to guide the sonic energy in a preferred manner relative to the internal volume 12, such as focusing or defocusing the acoustic energy, through a 'lense' effect caused by the physical shape of the window 11 (such as an effect caused by a concave or convex shape). In some embodiments, the window 11 has an acoustic impedance similar to that of water and a relatively low acoustic absorption. One preferred material is low density polyethylene, but other polymers such as polypropylene, polystyrene, poly(ethylene teraphthalte) ("PET"), polyimide, and other rigid and flexible polymers may be used. If the window 11 is formed from a thin film material, the film may be a laminate to facilitate thermal bonding to the chamber 10. For example, the window 11 may be sealingly attached to the chamber 10 using heat sealing. Thicker, more rigid materials may also be employed for the window 11.

The upper portion of the chamber 10 may include an inspection window 16, which can be flat or domed or otherwise arranged to enclose the internal volume 12 while permitting visible light inspection of the internal volume 12. Such inspection may be done by a human, or by a suitably arranged sensor 21 such as a video camera, photodetector, IR detector, and so on. Characteristics of the material in the internal volume 12 detected by the sensor 21 may be used by the controller 20 to control the acoustic energy source 2 or other components of the system 1. For example, if excessive cavitation is to be avoided, the controller 20 may adjust the acoustic energy at the focal zone if the sensor 21 detects the presence of cavitation bubbles of a certain size and/or number. Other features may be detected by the sensor 21, such as the size, density or other characteristics of particles in the chamber 10 in the case where the acoustic treatment is intended to break down the size of particles in the sample material. Thus, the sensor 21 may detect whether acoustic treatment is progressing as desired and whether processing is complete, e.g., to trigger the introduction of additional sample material into the chamber 10. Like the window 11, the inspection window 16 may be formed of any suitable material, such as glass, sapphire, quartz, and/or polymer materials.

The body of the chamber 10 may be made of any material or combination of materials suitable to contain the material in the internal volume 12 during treatment, to act as an environmental seal, and/or to provide a thermal transfer mechanism. In some embodiments, the chamber 10 may be made of a rigid or flexible material, such as a thermally conductive metal or polymer, or a combination of such materials. Preferably, the material used for the chamber 10 has a low acoustic absorption and acceptable heat transfer properties for a desired application. In certain embodiments, the upper portion of the chamber 10 (e.g., including the inspection window 16) can be arranged to reflect acoustic energy back into the internal volume 12, providing additional process efficiencies. If the chamber 10 is made from multiple parts, such as by upper and lower members, the members may be joined together by thermal bonding, adhesive bonding, external clamping, mechanical fasteners (such as the bolts shown in FIG. 16) with an o-ring or other gasket to form a seal between the members, welding, and so on. If the bond is to be achieved by thermal bonding, the upper and lower members may be made of, or include, film laminates having heat bondable outer layers and heat resistant inner layers.

As can be seen in FIG. 17, the acoustic treatment system 1 may include a vessel 503 that contains the acoustic energy source 2, the chamber 10 as well as a coupling medium 4. The vessel 503 may take any suitable size, shape or other configuration, and may be made of any suitable material or combination of materials (such as metal, plastic, composites, etc.). In this illustrative embodiment, the vessel 503 has ajar- or can-like configuration with an opening 31 arranged to permit access to an internal volume of the vessel 503. The acoustic energy source 2 and the coupling medium 4 (such as water or other liquid, or optionally a solid material) may be positioned in the vessel 503, e.g., with the acoustic energy source 2 near a bottom of the vessel 503. (If the coupling material 4 is solid, the vessel 503 and the coupling medium 4 may be essentially integrated with each other, with the coupling medium 4 essentially functioning as an acoustic coupling as well as a physical attachment of the acoustic source 2 and the chamber 10.) The opening 31 may be arranged so that the chamber 10 can be lowered into the vessel 503, e.g., so that the chamber 10 is partially or completely submerged in the coupling medium 4. The coupling medium 4 may function as both an acoustic coupling medium, e.g., to transmit acoustic energy from the acoustic energy source 2 to the window 11, as well as a thermal coupling medium, e.g., to accept heat energy from the chamber 10. In other embodiments, the thermal and acoustic coupling medium may be separate, e.g., where the chamber 10 is provided with a cooling jacket 19 like that in FIG. 18.

In this illustrative embodiment, the opening 31 is sized and shaped to receive the chamber 10, which has a barrel shape in this embodiment with the inlet 13 and outlet 14 extending generally along the longitudinal axis of the barrel shape of the chamber 10. A cap 517 is engaged with the inlet 13 and outlet 14 conduits and is arranged so that the chamber 10 may be suspended in the coupling medium 4, supported by the inlet and outlet conduits and the cap 517. The chamber 10 may be positioned in the vessel 503 so that a focal zone of acoustic energy created by the acoustic energy source 2 is suitably located in the internal volume 12 of the chamber 10. Thus, assembly of the system 1 may be eased because appropriate positioning of the chamber 10 relative to the acoustic energy source 2 may be achieved by simply engaging the cap 517 with the opening 31 of the vessel 503. No adjustment of the chamber 10 position in the vessel 503 need be required as long as the chamber is suitably positioned relative to the cap 517 and the cap 517 is properly engaged with the vessel 503. The cap 517 may engage with the opening 31 of the vessel 503 so that not only the cap 517/chamber 10 are supported by the vessel 503, but also so that the vessel opening 31 is sealed or otherwise closed by the cap 517, e.g., to help prevent contamination of the coupling medium 4. The inlet and outlet conduits may pass through the cap 517, e.g., for fluid connection to supply and/or return lines or other conduits that carry the material to be treated in the chamber 10.

It should be understood that the chamber 10 may be arranged in any suitable way, and for a variety of different applications. For example, in the embodiment shown in FIG. 17, the inlet 13 and outlet 14 communicate with the internal volume 12 on opposite sides of the volume 12 and at a same vertical level. However, the inlet 13 and outlet 14 may communicate with the internal volume 12 in other ways, e.g., the inlet 13 may be fluidly coupled with the internal volume 12 at a location that is above, or below, of a location where the outlet is fluidly coupled to the internal volume. Having the inlet and outlet coupled at different heights may provide advantages depending on the specific application. For example, in some applications, having the inlet located above the outlet may help control the temperature of the material in the internal volume 12, e.g., cooler fluid entering at the inlet may mix with relatively warm fluid near a top of the internal volume 12. In other applications, having the inlet below the outlet may help ensure that material having a desired size or density is encouraged to exit at the outlet, e.g., larger, more dense particles may remain in the internal volume 12 below the outlet until the particles are broken down by the acoustic treatment into a desired size/density range. In the case of a water jacketed chamber, positioning the inlet and outlet at opposite ends of the chamber can enable counter-flow heat exchanger operation and improved heat transfer and temperature control of the sample.

In accordance with another aspect of the invention, the chamber 10 may include one or more insert elements that may be provided in the internal volume 12 to define, at least in part, a shape and size of the internal volume. For example, as shown in FIG. 19, an insert element 518 having a sleeve arrangement with an outer cylindrical shape and an inner conical or frustoconical shape may be provided in the internal volume 12 to define the size and shape of the internal volume 12 where acoustic treatment will take place. In this embodiment, the inner space defined by the insert element 518 functions as the internal volume 12 where material is acoustically treated. The insert element 518 may be made in a variety of different shapes, sizes and materials, depending on the application or other desired function. For example, the insert element 518 may include a plurality of nucleation sites, e.g., provided by the surface of a ceramic material of the insert element 518, that serve as initiation sites for cavitation. Other arrangements are possible, including ceramic rods, beads or elements made of other materials, that are positioned in the internal volume 12 and function to provide nucleation sites, to help transfer or otherwise distribute heat in the chamber 10, provide reaction sites or otherwise catalyze or aid in chemical or other reactions in the volume 12, and other functions. The rods, beads or other structures may be suspended in the internal volume 12, e.g., as shown in FIG. 20 by a physical support and/or by mixing or other fluid movement in the internal volume caused by the acoustic energy or other material flow.

In accordance with an aspect of the invention, the system 1, e.g., as shown in FIGs. 16 and 17 as well as other embodiments described below, may be arranged to accommodate continuous acoustic treatment of material in a chamber 10, or multiple chambers 10, for an extended time period, e.g., for 1 hour or more, at a relatively high intensity, e.g., at an output of the acoustic transducer of 200 watts or more, without experiencing excessive heat buildup or other problems. In one embodiment, a piezoelectric transducer functioning at part of the acoustic energy source 2 may operate at an intensity level equal to about 286 watts for several hours in an equilibrium state, i.e., a state in which material is acoustically processed in a chamber 10 without excessive heat build up, transducer burn out or failure, or other conditions that would require stoppage of the acoustic treatment. This is in contrast to prior acoustic treatment arrangements in which continuous acoustic treatment for 1 hour or more could not have been achieved for a variety of different reasons, such as excessive heat buildup, failure of the acoustic source (e.g., due to transducer overheating and subsequent burn out), damage to the sample material, and so on.

### Transducer

In certain embodiments, the sonic energy source 2 may include, for example, an ultrasound transducer or other transducer, that produces acoustic waves in the "ultrasonic" frequency range. Ultrasonic waves start at frequencies above those that are audible, typically about 20,000 Hz or 20 kHz, and continue into the region of megahertz (MHz) waves. The speed of sound in water is about 1000 meters per second, and hence the wavelength of a 1000 Hz wave in water is about a meter, typically too long for specific focusing on individual areas less than one centimeter in diameter, although usable in non-focused field situations. At 20 kHz the wavelength is about 5 cm, which is effective in relatively small treatment vessels. Depending on the sample and vessel volume, preferred frequencies may be higher, for example, about 100 kHz, about 1 MHz, or about 10 MHz, with wavelengths, respectively, of approximately 1.0, 0.1, and 0.01 cm. In contrast, for conventional sonication, including sonic welding, frequencies are typically approximately in the tens of kHz, and for imaging, frequencies are more typically about 1 MHz and up to about 20 MHz. In lithotripsy, repetition rates of pulses are fairly slow, being measured in the hertz range, but the sharpness of the pulses generated give an effective pulse wavelength, or in this case, pulse rise time, with frequency content up to about 100 to about 300 MHz, or 0.1-0.3 gigahertz (GHz).

The frequency used in certain embodiments of the invention also will be influenced by the energy absorption characteristics of the sample or of the chamber 10, for a particular frequency. To the extent that a particular frequency is better absorbed or preferentially absorbed by the sample material, it may be preferred. The energy can be delivered in the form of short pulses or as a continuous field for a defined length of time. The pulses can be bundled or regularly spaced.

A generally vertically oriented focused ultrasound beam may be generated in several ways by the acoustic energy source 2. For example, a single-element piezoelectric transducer, such as those supplied by Sonic Concepts, Woodinville, Wash., that can be a 1.1 MHz focused single-element transducer, can have a spherical or other curved transmitting surface that is oriented such that the focal axis is vertical. Another embodiment uses a flat unfocused transducer and an acoustic lens (e.g., the window 11 or other element) to focus the beam. Still another embodiment uses a multi-element transducer such as an annular array in conjunction with focusing electronics to create the focused beam. The annular array potentially can reduce acoustic sidelobes near the focal point by means of electronic apodizing, that is by reducing the acoustic energy intensity, either electronically or mechanically, at the periphery of the transducer. This result can be achieved mechanically by partially blocking the sound around the edges of a transducer or by reducing the power to the outside elements of a multi-element transducer. This reduces sidelobes near the energy focus, and can be useful to reduce heating of the chamber 10. Alternatively, an array of small transducers can be synchronized to create a converging beam. Still another embodiment combines an unfocused transducer with a focusing acoustic mirror to create the focused beam. This embodiment can be advantageous at lower frequencies when the wavelengths are large relative to the size of the transducer. The axis of the transducer of this embodiment can be horizontal and a shaped acoustic mirror used to reflect the acoustic energy vertically and focus the energy into a converging beam.

In certain embodiments, the focal zone can be small relative to the dimensions of the treatment chamber 10 to avoid heating of the treatment chamber 10. In one embodiment, the focal zone has a width of approximately 1 mm. Heating of the treatment chamber 10 can be reduced by minimizing acoustic sidelobes near the focal zone. Sidelobes are regions of high acoustic intensity around the focal point formed by constructive interference of consecutive wavefronts. The sidelobes can be reduced by apodizing the transducer either electronically, by operating the outer elements of a multi-element transducer at a lower power, or mechanically, by partially blocking the acoustic waves around the periphery of a single element transducer. Sidelobes may also be reduced by using short bursts, for example in the range of about 3 to about 5 cycles in the treatment protocol.

The transducer can be formed of a piezoelectric material, such as a piezoelectric ceramic. The ceramic may be fabricated as a "dome", which tends to focus the energy. One application of such materials is in sound reproduction; however, as used herein, the frequency is generally much higher and the piezoelectric material would be typically overdriven, that is driven by a voltage beyond the linear region of mechanical response to voltage change, to sharpen the pulses. Typically, these domes have a longer focal length than that found in lithotriptic systems, for example, about 20 cm versus about 10 cm focal length. Ceramic domes can be damped to prevent ringing. The response is linear if not overdriven. The high-energy focus zone of one of these domes is typically cigar-shaped. At 1 MHz, the focal zone is about 6 cm long and about 2 cm wide for a 20 cm dome, or about 15 mm long and about 3 mm wide for a 10 cm dome. The peak positive pressure obtained from such systems is about 1 MPa (mega Pascal) to about 10 MPa pressure, or about 150 PSI (pounds per square inch) to about 1500 PSI, depending on the driving voltage. The focal zone, defined as having an acoustic intensity within about 6 dB of the peak acoustic intensity, is formed around the geometric focal point.

The wavelength, or characteristic rise time multiplied by sound velocity for a shock wave, is in the same general size range as a biological cell, for example about 10 to about 40 micron. This effective wavelength can be varied by selection of the pulse time and amplitude, by the degree of focusing maintained through the interfaces between the source and the material to be treated, and the like.

Another source of focused acoustic pressure waves is an electromagnetic transducer and a parabolic concentrator, as is used in lithotripsy. The excitation of such devices tends to be more energetic, with similar or larger focal regions. Strong focal peak negative pressures of about -16 MPa have been observed. Peak negative pressures of this magnitude provide a source of cavitation bubbles in water, which can be desirable in an extraction process.

### Drive Electronics and Waveform Control

One treatment protocol for treating material with acoustic energy in the chamber 10 can include variable acoustic waveforms combined with sample motion and positioning to achieve a desired effect. The acoustic waveform of the transducer may have many effects, including: acoustic microstreaming in and near cells due to cavitation, that is flow induced by, for example, collapse of cavitation bubbles; shock waves due to nonlinear characteristics of the fluid bath; shock waves due to cavitation bubbles; thermal effects, which lead to heating of the sample, heating of the sample vessel, and/or convective heat transfer due to acoustic streaming; flow effects, causing deflection of sample material from the focal zone due to shear and acoustic pressure, as well as mixing due to acoustic streaming, that is flow induced by acoustic pressure; and chemical effects. The waveform of focused sound waves can be a single shock wave pulse, a series of individual shock wave pulses, a series of shock wave bursts of several cycles each, or a continuous waveform. Incident waveforms can be focused directly by either a single element, such as a focused ceramic piezoelectric ultrasonic transducer, or by an array of elements with their paths converging to a focus. Alternatively, multiple foci can be produced to provide ultrasonic treatment to multiple treatment zones, vessels, or wells. Additionally, the flow of the sample material into, or out of the processing chamber 10 can interact with the acoustic effects, and the acoustic streaming can be modified to enhance this sample flow in a desirable manner.

The treatment protocol can be optimized to maximize energy transfer while minimizing thermal and flow effects. The treatment protocol also can effectively mix the contents of the treatment chamber 10, in the case of a particulate sample suspended in a liquid. Energy transfer into the sample can be controlled by adjusting the parameters of the acoustic wave such as frequency, amplitude, and cycles per burst. Temperature rise in the sample can be controlled by limiting the duty cycle of the treatment and by optimizing heat transfer between the treatment chamber 10 and the coupling medium 4. Heat transfer can be enhanced by making the treatment chamber 10 with thin walls, of a relatively highly thermally conductive material, and/or by promoting forced convection by acoustic streaming in the treatment chamber 10 and in the fluid bath in the proximity of the treatment chamber 10. Additionally, the chamber 10 can be modified to enhance the thermal coupling between the sample and the exterior environment by providing enhanced surface treatments such as increased area such as fins, an actively pumped water jacket, and/or high conductivity vessel materials. Monitoring and control of temperature is discussed in more detail below.

For example, for a cellular disruption and extraction treatment, an example of an effective energy waveform is a high amplitude sine wave of about 1000 cycles followed by a dead time of about 9000 cycles, which is about a 10% duty cycle, at a frequency of about 1.1 MHz. The sine wave electrical input to the transducer typically results in a sine wave acoustic output from the transducer. As the focused sine waves converge at the focal point, they can become a series of shock waves due to the nonlinear acoustic properties of the water or other fluid in the coupling medium 4. This protocol treats the material in the focal zone effectively during the "on" time. As the material is treated, it is expelled from the focal zone and new material circulates into the focal zone. The acoustic "on" and "off" times can be cycled to be effective, for example, for extracting the cellular contents of ground or particulate leaf tissue, while causing minimal temperature rise in the treatment vessel.

Further advantage in disruption and other processes may be gained by creating a high power "treat" interval alternating with a low power "mix" interval. More particularly, in this example, the "treat" interval utilizes a sine wave that has a treatment frequency, a treatment cycles-per-burst count, and a treatment peak-to-peak amplitude. The "mix" interval has a mix frequency, a mix cycles-per-burst count and a lower mix peak-to-peak amplitude. Following each of the intervals is a dead time. Of course, these relationships are merely one example of many, where one interval in considered to be high power and one interval is considered to be low power, and these variables and others can be altered to produce more or less energetic situations. Additionally, the treat function or interval and the mix function or interval could emit from different or multiple transducers in the same apparatus, optionally emitting at different frequencies.

High power/low power interval treatments can allow multiple operations to be performed, such as altering permeability of components, such as cells, within the sample followed by subsequent mixing of the sample. The treat interval can maximize cavitation and bioeffects, while the mix interval can maximize mixing within the treatment vessel and/or generate minimal heat. Adding a longer, high power "super-mix" interval occasionally to stir up particles that are trapped around the periphery of the chamber 10 can provide further benefits. This "super-mix" interval generates additional heat, so it is programmed to treat infrequently during the process, for example, every few seconds. Additionally, dead times between the mix and treat intervals, during which time substantially no energy is emitted from the sonic energy source, can allow fresh material to circulate into the energy focal zone of the target.

The waveform of the sound wave typically is selected for the particular material being treated. For example, to enhance cavitation, it can be desirable to increase the peak negative pressure following the peak positive pressure. For other applications, it can be desirable to reduce cavitation, but maintain the peak positive pressure. This result can be achieved by performing the process in a pressurized chamber 10 at a slight pressure above ambient. For example, if the waveform generated has a peak negative pressure of about -5 MPa, then the entire chamber may be pressurized to about 10 MPa to eliminate cavitation from occurring during the process. Material to be treated can be pressurized on a batch or a continuous basis within the internal volume 12 of the chamber 10. That is, a volume of material may be delivered into the internal volume 12, treated acoustically while material flow is stopped, and then a new volume of material may be delivered into the internal volume 12 once treatment of the initial volume is complete.

Typically, the shock wave is characterized by a rapid shock front with a positive peak pressure in the range of about 15 MPa, and a negative peak pressure in the range of about negative 5 MPa. This waveform is of about a few microseconds duration, such as about 5 microseconds. If the negative peak is greater than about 1 MPa, cavitation bubbles may form. Cavitation bubble formation also is dependent upon the surrounding medium. For example, glycerol is a cavitation inhibitive medium, whereas liquid water is a cavitation promotive medium. The collapse of cavitation bubbles forms "microjets" and turbulence that impinge on the surrounding material.

Control of the acoustic energy source 2 may be performed by the controller 20 using a feedback control mechanism so that any of accuracy, reproducibility, speed of processing, control of temperature, provision of uniformity of exposure to sonic pulses, sensing of degree of completion of processing, monitoring of cavitation, and control of beam properties (including intensity, frequency, degree of focusing, wave train pattern, and position), can enhance performance of the treatment system 1. A variety of sensors or sensed properties may be used by the controller 20 for providing input for feedback control. These properties can include sensing of temperature of the sample material; sonic beam intensity; pressure; coupling medium properties including temperature, salinity, and polarity; sample material position; conductivity, impedance, inductance, and/or the magnetic equivalents of these properties, and optical or visual properties of the sample material. These optical properties, which may be detected by the sensor 21 typically in the visible, IR, and UV ranges, may include apparent color, emission, absorption, fluorescence, phosphorescence, scattering, particle size, laser/Doppler fluid and particle velocities, and effective viscosity. Sample integrity or comminution can be sensed with a pattern analysis of an optical signal from the sensor 21. Particle size, solubility level, physical uniformity and the form of particles could all be measured using instrumentation either fully stand alone sampling of the fluid and providing a feedback signal, or integrated directly with the focused acoustical system via measurement interface points such as an optical window. Any sensed property or combination thereof can serve as input into a control system. The feedback can be used to control any output of the system, for example beam properties, sample position or flow in the chamber 10, treatment duration, and losses of energy at boundaries and in transit via reflection, dispersion, diffraction, absorption, dephasing and detuning.

According to certain embodiments of the present invention, several aspects of the treatment system 1 can enhance the reproducibility and/or effectiveness of particular treatments using ultrasonic energy in in vitro applications, where reproducibility, uniformity, and precise control are desired. These aspects include the use of feedback, precise focusing of the ultrasonic energy, monitoring and regulating of the acoustic waveform (including frequency, amplitude, duty cycle, and cycles per burst), positioning of the chamber 10 relative to the ultrasonic energy so that the sample material is uniformly treated, controlling movement or flow of the sample relative to the focus of ultrasonic energy during a processing step, and/or controlling the temperature of the sample being treated, either by the ultrasonic energy parameters or through the use of temperature control devices such as a water bath. A treatment protocol can be optimized, using one or a combination of the above variables, to maximize, for example, shearing, extraction, permeabilization, comminution, stirring, or other process steps, while minimizing undesirable thermal effects.

In one embodiment of the invention, high intensity ultrasonic energy is focused on a chamber 10, and "real time" feedback relating to one or more process variables is used to control the process. In another embodiment, the process is automated and is used in a high throughput system, such as a continuous flowing stream of material to be treated, optionally segmented.

In certain embodiments, the processing system can include a high intensity transducer that produces acoustic energy when driven by an electrical or optical energy input; a device or system for controlling excitation of the transducer, such as an arbitrary waveform generator, an RF amplifier, and a matching network for controlling parameters such as time, intensity, and duty cycle of the ultrasonic energy; a system or method for transferring material into and out of the process zone, either actively or passively, to allow automation and the implementation of feedback from monitoring; a temperature sensor; a device for controlling temperature; one or more reaction chambers 10; and a sensor for detecting, for example, optical, radiative, and/or acoustic signatures. The feedback signal can also come from a signal provided by either external or integrated measurement methods such as particle size, solubility, and form factors.

Additional aspects of the invention relate to material flow circuit arrangements for acoustically treating the material. For example, in some embodiments the sample material can be transferred to/from the treatment chamber through passive or active means, with the use of direct pumping methods or passive gravity driven methods.

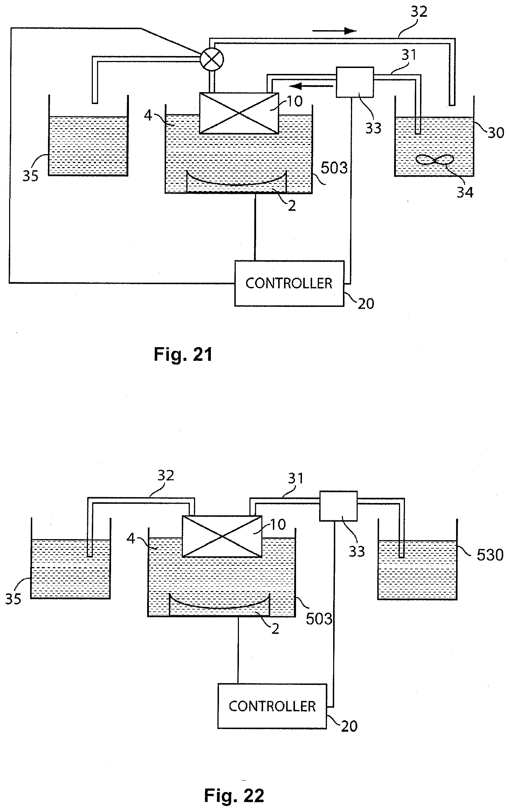

In one illustrative embodiment shown schematically in FIG. 22, an acoustic treatment system 1 may include one or more treatment chambers 10 that is fluidly coupled to a reservoir 30 that holds material to be treated in the chamber 10. In this illustrative embodiment, the inlet 13 of the chamber 10 is fluidly coupled to a supply conduit 31 and the outlet 14 of the chamber 10 is fluidly coupled to a return conduit 32. Thus, material in the reservoir 30 may be circulated through the chamber 10 at any suitable flow rate, pressure, time or other parameter so that the material is suitably processed by acoustic energy in the chamber 10. Flow of the material may be caused by gravity, by acoustic streaming (e.g., in the chamber 10), by a pump 33 (such as a syringe pump, a peristaltic pump, a gear pump, and so on), or other motive force. In some embodiments, a pressure may be maintained in the chamber 10 (and/or in the reservoir 30) by applying a pressurized gas, a pump or other component to generate the desired pressure in the desired locations. As discussed above, pressurizing the material in the chamber 10 and/or elsewhere may help reduce cavitation, enhance reaction rates, and/or have other desired affects.

In one aspect of the invention, the reservoir 30 may include an agitator 34, such as a mixing blade, stirrer, homogenizer or other device that functions to mechanically mix, shear or otherwise cause movement of the material in the reservoir 30. Movement of the material may have desired affects, such as pretreating the material prior to acoustic treatment, maintaining a desired distribution of material components throughout the volume in the reservoir, and so on. An arrangement like that in FIG. 21 may allow the system 1 to repeatedly expose the material to acoustic treatment so that the material has desired properties when treatment is complete. The acoustic treatment conditions in the chamber 10 may remain constant, or nearly constant throughout the process, or the conditions may change over time. For example, the material may initially include relatively large particles of a substance to be broken down into smaller particles and ultimately solublized in a carrier liquid. Initial acoustic treatment conditions (as well as operation of the agitator 34) may be favorable to break the large particles down into smaller particles. After some initial treatment, the large particles may be broken down, and the acoustic treatment conditions (and the operaton of the agitator 34) may be adjusted to enhance the speed and effectiveness of putting components of the small particles into solution. Adjustments to the treatment conditions may be made based on any suitable criteria, such as sensed material properties (such as particle size, density, etc.), a time elapsed, user input, and so on. The system 1 may optionally include a second reservoir 35 that receives material when processing of the material is determined to be complete (again, which determination may be made based on detected material properties, elapsed time, etc.). In this embodiment, the return conduit 32 includes a three-way valve 36 (or other suitable arrangement) that permits the controller 20 to direct material to the second reservoir 35 as desired. Of course, other flow control arrangements may be used, and control of material flow to the second reservoir 35 may be based on sensed parameters, such as elapsed processing time, detected particle sizes or density, material color or other optical properties, or other characteristics of the sample material.

FIG. 22 shows another illustrative embodiment for an acoustic treatment system 1 that includes a first reservoir 30 fluidly coupled to a chamber 10 via a supply conduit 31, and a second reservoir 35 fluidly coupled to the chamber 10 via a return conduit 32. In this embodiment, material in the first reservoir 30 may flow through the chamber 10 for acoustic treatment, and thereafter be deposited in the second reservoir 35. In the case that subsequent acoustic treatment is desired, the material may be again caused to flow through the chamber 10, albeit in the opposite direction and into the first reservoir 30 after a second treatment. Flow of the material may be caused in any suitable way, such as by a pump 33, by acoustic streaming in the chamber 10, by gravity (e.g., by establishing the level of material in one reservoir to be higher than the other, causing a siphon to be created for flow), or others. The chamber 10 and/or the conduits 31, 32 may include one or more window, sensors or other components suitable to detect properties of the sample material. These detected features may be used to control various parameters of the system 1, such as flow rate, pressure, acoustic treatment characteristics, and so on.

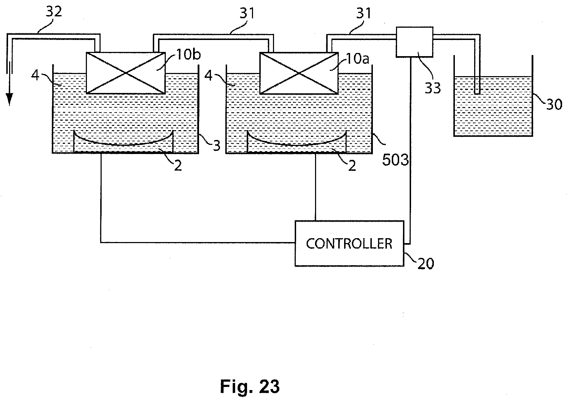

In another illustrative embodiment, an acoustic treatment system 1 may include two or more treatment chambers 10 that are arranged in serial fashion. For example, FIG. 23 shows an embodiment in which two chambers 10 are in fluid communication with each other and a reservoir 30. The first chamber 10a may be used to apply a 'pretreatment' or other first treatment to the sample material, while the second chamber 10b applies a 'finishing" or other second treatment to the material. The acoustic energy and other treatment parameters may be set and controlled independently at each chamber 10 to optimize the overall processing goals. For example, the sample material can first pass through a 'roughing' stage in the first chamber 10a to break up large chunks/clumping in the sample material (e.g., where the treatment conditions provide a general, high level mixing and homogenization of the sample) before the material passes to the next stage (e.g., a 'finishing' stage) for additional acoustic treatment that refines the ultimate properties of the material, such as by extracting desired materials, solubilizing components in the material, and so on. As many stages, i.e., chambers 10, as is necessary may be used in a system 1 like that in FIG. 23 to achieve the desired output.

Aspects of the invention also relate to methods for acoustically treating material using the various systems 1 described above. For example, one method in accordance with the invention involves treating a material using a system like that in FIG. 21 wherein material is agitated by an agitator in a reservoir, the material is caused to flow from the reservoir into a chamber 10, the material is exposed to focused acoustic energy in the internal volume of the chamber 10 (where the acoustic energy at a focal zone has the properties described herein), and the material is caused to flow back to the reservoir. Optionally, a processing state of the material may be detected, e.g., while the material is in the chamber 10 or return conduit, and if the material is suitably processed, the material may be caused to flow to another reservoir. Relatively large volumes of material, such as 1 gallon, 10 gallons, 100 gallons, 1000 gallons or more of material may be held in the reservoir and caused to flow in a circulatory manner through one or more chambers 10 in a continuous fashion. Thus, the treatment method may be continuously performed for 1 hour or more, with the acoustic energy source continuously operating at a power output equivalent to 200 watts or more.

Another method in accordance with the invention relates to treating material using a system like that in FIG. 22 or a similar system. For example, material may be caused to flow in a first direction into a chamber 10, the material is exposed to focused acoustic energy in the internal volume of the chamber 10 (where the acoustic energy at a focal zone has the properties described herein), and the material is caused to flow out of the chamber 10. Thereafter, the material may be caused to flow in a second direction opposite to the first direction into the chamber 10, where the material is again acoustically treated, and flows in the second direction out of the chamber 10. Flow may be caused by one or more pumps, acoustic streaming, gravity and/or other motive forces. Also, acoustic treatment may be performed in a continuous manner, for extended periods of time (over 1 hour) with the acoustic energy source 2 operation at a power output of 200 watts or greater. As with other methods in accordance with the invention, various aspects may be combined together, such as chambers that include acoustic windows, chambers that include heat exchanger features, and so on.

Another method in accordance with the invention relates to treating material using a system like that in FIG. 23 or a similar system. For example, material may be caused to flow into a first chamber 10, the material is exposed to focused acoustic energy in the internal volume of the first chamber 10 (where the acoustic energy at a focal zone has the properties described herein), and the material is caused to flow out of the first chamber 10, and into a second chamber 10, where the material is again acoustically treated. Serial treatment of the material may be repeated with three or more chambers, and the treatment conditions may be the same, or different, in the different chambers 10. Acoustic treatment may be performed in a continuous manner, for extended periods of time (over 1 hour) with the acoustic energy source 2 operation at a power output of 200 watts or greater. As with other methods in accordance with the invention, various aspects may be combined together, such as chambers that include acoustic windows, chambers that include heat exchanger features, and so on.
Temperature, Cavitation, Particle Size, Solubility, and Pressure Management and Control.

### Visual Monitoring of the Sample

Optical or video detection and analysis can be employed to optimize treatment of the sample. For example, in a suspension of biological tissue, the viscosity of the mixture can increase during treatment due to the diminution of the particles by the treatment and/or by the liberation of macromolecules into the solution. Video analysis of the sample during treatment allows an automated assessment of the mixing caused by the treatment protocol. The protocol may be modified during the treatment to promote greater mixing as a result of this assessment. The video data may be acquired and analyzed by the computer control system (i.e., part of the controller 20) that is controlling the treatment process. Other optical measurements such as spectral excitation, absorption, fluorescence, emission, and spectral analysis also can be used to monitor treatment of the sample, whether in the chamber 10 or in a flow path upstream or downstream of the chamber 10. A laser beam, for example, can be used for alignment and to indicate current sample position. In certain embodiments the visual or optical detection can be performed through a window in the reaction chamber. This window can be the upper or lower window of the chamber 10, a visual window integrated into the vessel side itself, or can be a window integrated into the transfer tubing or sample reservoir.

### Temperature Control

Certain applications require that the temperature of the sample being processed be managed and controlled during processing. For example, many biological samples should not be heated above 4 degrees C during treatment. Other applications require that the samples be maintained at a certain elevated temperature during treatment. The ultrasound treatment protocol influences the sample temperature in several ways: the sample absorbs acoustic energy and converts it to heat; the sample treatment chamber absorbs acoustic energy and converts it to heat which, in turn, can heat the sample; and acoustic streaming develops within the sample treatment chamber and the coupling medium, forcing convective heat transfer between the sample treatment chamber and the coupling medium.

The acoustic waves or pulses can be used to regulate the temperature of the solutions in the treatment chamber. At low power, the acoustic energy produces a slow stirring without marked heating. Although energy is absorbed to induce the stirring, heat may be lost rapidly through the sides of the treatment chamber, resulting in a negligible equilibrium temperature increase in the sample. At higher energies, more energy is absorbed, and the temperature rises. The degree of rise per unit energy input can be influenced and/or controlled by several characteristics, including the degree of heat absorption by the sample or the treatment chamber and the rate of heat transfer from the treatment chamber to its surroundings (e.g., the coupling medium). Additionally, the treatment protocol may alternate a high-powered treatment interval, in which the desired effects are obtained, with a low power mixing interval, in which acoustic streaming and convection are achieved without significant heat generation. This convection may be used to promote efficient heat exchange or cooling.

The sample temperature may be required to remain within a given temperature range during a treatment procedure. Temperature can be monitored remotely by, for example, an infra-red sensor. Temperature probes such as thermocouples may not be particularly well suited for all applications because the sound beam may interact with the thermocouple and generate an artificially high temperature in the vicinity of the probe. Temperature can be monitored by the same computer that controls acoustic waveform. The control responds to an error signal which is the difference between the measured actual temperature of the sample and the target temperature of the sample. The control algorithm can be as a hysteritic bang-bang controller, such as those in kitchen stoves, where, as an output of the control system, the acoustic energy is turned off when the actual temperature exceeds a first target temperature and turned on when the actual temperature falls below a second target temperature that is lower than the first target temperature. More complicated controllers can be implemented. For example, rather than simply turning the acoustic signal on and off, the acoustic signal could continuously be modulated proportionally to the error signal, for example, by varying the amplitude or the duty cycle, to provide finer temperature regulation.

In the application of a bang-bang control algorithm for a multiple sample format, once a maximum temperature value has been exceeded and the sonic energy is turned off for a particular sample, an alternative to waiting for the sample to cool below a selected temperature before turning the sonic energy on again, is to move on to the next sample, or increase the flow rate of new sample material into the treatment chamber. Another alternative is to switch to a predefined "cooling" waveform which promotes convection without adding significant heat to a particular sample, and synchronizing this cycle with the introduction of new sample material to the chamber.

### MORE EMBODIMENTS

Aspects of the present disclosure relating to reproducible formation of large volumes of nanocrystalline particles through crystal growth can be used in combination with further description below which relates to treating material with acoustic energy, including systems in which sample material is contained within or flows through a processing zone of a chamber.

In some embodiment, flow through processing as described herein can enable some types of acoustic treatment and/or treatment efficiencies that are not possible with non-flow through techniques. In some embodiments, a method of acoustically treating a sample material includes creating one or more secondary focal zones in a treatment chamber, and using those secondary focal zones to help acoustically treat material in the chamber. For example, an acoustic energy source may create a focal zone of acoustic energy by focusing energy emitted by an acoustic transducer to a location in a treatment chamber containing sample material. Acoustic energy that is scattered or otherwise emanates from the focal zone may be reflected or otherwise manipulated (e.g., by the geometry defined by the chamber wall) to create secondary focal zones or reflections back into the treatment chamber thereby establishing a non-contact, pressure drop environment which aids mixing. These secondary focal zones may help with acoustic treatment, such as by inducing mixing, disruption of molecular bonds, flow of the sample material in a desired direction, etc. Thus, acoustic treatment may be made more efficient, e.g., in part because sonic energy that would otherwise be emitted from the treatment chamber may be used for acoustic treatment in the chamber.

In some embodiments, these reflected energies are directed inward to create a process 'zone', where the energies are directed to a process region. The shape of the chamber geometries can be modified to accommodate a range of pressures within this process zone. This may be desirable for certain materials such as biological samples, where a larger more uniform process zone creates an overall more effective processing since the energy density across a larger integrated volume of material is above a certain threshold.

In one embodiment, an acoustic treatment method includes providing a sample to be acoustically treated into an internal volume of a chamber having a wall with an inner side. The sample may include any suitable material, such as a liquid, solid, mixtures, suspensions or other combinations of liquids and solids, etc. The chamber may have any suitable size, shape or other arrangement, e.g., may be a single isolated vessel or an arrangement that permits flow of material through a space. Acoustic energy, having a frequency of about 100 kHz to 100 MHz, may be transmitted from an acoustic energy source that spaced from the chamber. For example, an acoustic transducer that includes one or more piezoelectric elements may be used to emit acoustic waves having a suitable arrangement to form a focal zone at least partially within the chamber. The acoustic energy may be transmitted through a coupling medium, such as a liquid and/or solid, to the internal volume. Acoustic energy that might otherwise exit the chamber may be reflected to form a secondary focal zone in the chamber. For example, the chamber may include a wall that is thin, substantially transparent to acoustic radiation and surrounded by air or other gas so as to provide a gas/chamber wall interface. In this embodiment, the gas/chamber wall interface may provide a suitable difference in acoustic impedance or other acoustic property relative to the sample material so that acoustic energy is reflected at the gas/chamber wall interface and back into the internal volume of the chamber. This reflected energy may be focused or otherwise directed to form one or more secondary focal zones in the chamber. In an alternative embodiment, the chamber wall material itself could be made from a high impedance material, thus causing direct reflection back into the processing zone.

In another illustrative embodiment, a system for treating a material with acoustic energy includes a chamber having a wall with an inner side defining an internal volume and arranged to cause reflection of acoustic energy in the chamber to form a secondary focal zone in the chamber. An acoustic energy source may be spaced from the chamber and arranged to emit acoustic energy having a frequency of about 100 kHz to 100 MHz to create a focal zone of acoustic energy in the internal volume. A coupling medium, e.g., including a liquid and/or a solid, may be arranged to transmit acoustic energy from the acoustic energy source to the internal volume. The chamber may have an opening into the internal volume (e.g., at a bottom of the chamber), an inlet to receive an inflow of material into the internal volume and an outlet to discharge an outflow of material from the internal volume. In one embodiment, the chamber wall may be substantially transparent to acoustic energy having a frequency of about 100 kHz to 100 MHz. A window may be provided in the opening of the chamber and be arranged to sealingly close the opening and to transmit focused acoustic energy into the chamber for treatment of material in the internal volume. The window, which may be formed unitarily, integrally or otherwise with the chamber wall, may be generally transparent to acoustic energy having a frequency of about 100 kHz to 100 MHz. A housing may be attached to the chamber and window so that the window is exposed at a lower end of the housing, and the chamber is located in an inner space of the housing. This arrangement may allow the housing to maintain contact of an outer side of the chamber wall with a gas in regions above the window, e.g., where the lower end of the housing and the window are submerged in a liquid coupling medium. An interface between the chamber wall and the gas may have a focusing effect on acoustic energy in the internal volume to create one or more secondary focal zones of acoustic energy in the internal volume. For example, acoustic energy that is scattered or otherwise emitted from the focal zone created by the acoustic energy source may be reflected by the interface back into the internal volume for the creation of the secondary focal zone(s). The chamber may have a dome shape, e.g., that includes a hemispherical portion, cylindrical portion, conical portion or other suitable shape to help focus or otherwise direct sonic energy. In one embodiment, an outlet to discharge an outflow of material from the internal volume may be located at an uppermost portion of the chamber, e.g., to help remove gas from the internal volume that is liberated during the acoustic treatment. This may help prevent interference of gas in the chamber with the acoustic energy. Additionally, it may ensure larger/heavier particles remain in the process zone until they are small enough to become buoyant and travel with the outgoing sample.

In one embodiment, the inlet to the chamber may intersect from the top of the chamber, but have an inlet tube that extends in the inside of the chamber to the bottom region, thus ensuring material must pass through the processing zone on its way to the outlet. This arrangement may be more important in a low flow and/or a low acoustic energy processing conditions.

In another aspect of the invention, a system for treating a material with acoustic energy may include a chamber having a wall with an inner side defining an internal volume and an outer side opposite the inner side that is substantially surrounded by a gas. An interface of the gas with the outer side of the chamber wall may help to reflect or otherwise direct acoustic energy from exiting the chamber and/or to create one or more secondary focal zones. This secondary focal zone formed of reflected acoustic energy may complement the focal zone created by the acoustic energy source, e.g., to aid in the acoustic treatment of the sample material. In one illustrative embodiment, the chamber may have a dome shape, e.g., with the upper portion of the dome arranged at a top of the chamber and farthest from the acoustic energy source. The dome shape of the chamber may be arranged to focus or otherwise direct acoustic energy to form a secondary focal zone. The chamber may have an opening into the internal volume, an inlet to receive an inflow of material into the internal volume and an outlet to discharge an outflow of material from the internal volume. In one embodiment, the chamber wall may be substantially transparent to acoustic energy having a frequency of about 100 kHz to 100 MHz, have a thickness of about 0.010 inches, and may be made of a polyethylene, PET, Teflon/FEP based, TPX (polymethylpentene), or other suitably acoustically transparent material. A window may be located at the opening of the chamber and be arranged to seal close the opening and to transmit focused acoustic energy into the chamber for treatment of material in the internal volume. The window may be generally transparent to acoustic energy having a frequency of about 100 kHz to 100 MHz, e.g., to help prevent loss of acoustic energy, heating of the window, etc. An acoustic energy source may be spaced from the window and the chamber and arranged to emit acoustic energy having a frequency of about 100 kHz to 100 MHz to create a focal zone of acoustic energy in the internal volume. A coupling medium, e.g., including a liquid and/or a solid, may be arranged to transmit acoustic energy from the acoustic energy source to the window. In one embodiment, the window may be in contact with the coupling medium, e.g., the window and other lower portions of the chamber may be submerged in a water bath. A housing may be attached to the chamber and window so that the window is exposed at a lower end of the housing and the chamber is located in an inner space of the housing. This arrangement may allow part of the housing to be submerged in a liquid coupling medium, placing the window in contact with the coupling medium. However, the housing may maintain a gas in contact with chamber wall even though parts of the chamber wall may be located below a top level of the coupling medium. The chamber and window may be arranged to maintain a pressurized environment in the internal volume, e.g., to help reduce cavitation, or to pull a vacuum to reduce gas content in the internal volume.

In some embodiments, the chamber can be sealed and have one or more inlets and outlets to the chamber for effective transfer of the bulk fluid material through the chamber. The chamber can be sealed during the treatment to prevent contamination of the sample material or of the environment. In some embodiments, arrays of chambers can be used for processing multiple sample streams in parallel, where very large sample volumes are needed, such as in manufacturing process streams. In some embodiments, the chambers and/or other components that contact a material processed may be made in a disposable form, e.g., for one time use in processing a material and discarded thereafter. The inlet and outlet may be located near a top of the chamber, and thus, the internal volume of the chamber may, in some sense, depend from the inlet and outlet or otherwise be positioned below at least the outlet. The inlet and outlet may each include a conduit that extends away from the chamber so that material may be introduced into the chamber even though the chamber may be otherwise completely sealed from an external environment. Flow of the material may be caused by a pump, gravity or other motive force, and the first and/or second conduits may be connected to a respective reservoir that serves to hold material as necessary.

### Apparatus and Methods for Ultrasonic Treatment

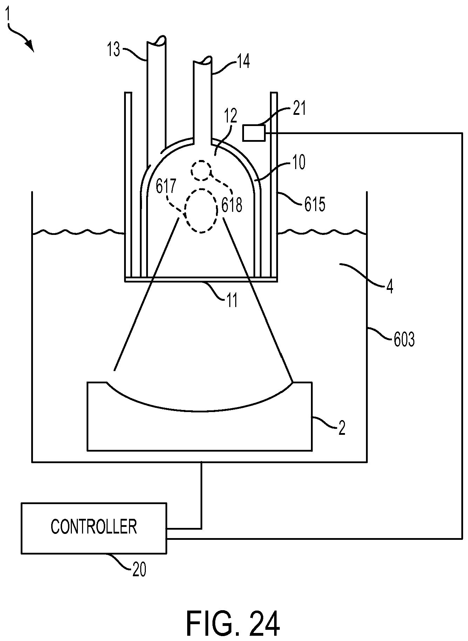

FIG. 24 shows one embodiment of an acoustic treatment system 1 in which focused acoustic energy generated by an acoustic energy source 2 passes through a coupling medium 4 (which may include a solid and/or a liquid, such as water) to an acoustic window 11 of a chamber 10 and into an internal volume 12 of the chamber 10 where the sample material is located. The acoustic treatment system 1 may include a controller 20 (e.g., including a suitably programmed general purpose computer or other data processing device) that receives control information (e.g., from one or more sensors, user input devices, etc.) and correspondingly controls operation of the acoustic energy source 2 and/or other system components. Sample material is provided into the internal volume 12 via an inlet 13, is acoustically treated in the internal volume 12, and is removed from the volume 12 via an outlet 14.

The acoustic energy source 2 may include an ultrasound transducer that projects a focused ultrasound beam or wave front toward the window 11 of the chamber 10. The window 11, which may sealingly close an opening in the chamber 10, may be suitably transparent to, or otherwise transmit acoustic energy so that the ultrasound beam penetrates the window 11 to form a focal zone 617 within the internal volume 12 that acts upon the sample material in the chamber 10. The window 11 may be configured to transmit a maximum amount of ultrasound energy to the material in the chamber 10, and/or control heat transfer between the internal volume 12 and, for example, an external water bath or other coupling medium 4. In certain embodiments, the window 11 is glass, sapphire, quartz or a polymer such as a polyimide or polymethylpentene. The window may have any suitable shape or other configuration, e.g., may be flat (or otherwise present a relatively flat surface to the impinging acoustic energy), or may be curved so as have a hemispherical or other convex shape, thereby allowing the acoustical energy to pass at an approximately 90 degree angle from the converging acoustic field. In certain embodiments, the window 11 is shaped to guide the sonic energy in a preferred manner relative to the internal volume 12, such as focusing or defocusing the acoustic energy, through a 'lense' effect caused by the physical shape of the window 11 (such as an effect caused by a concave or convex shape or other lens configuration). In some embodiments, the window 11 has an acoustic impedance similar to that of water (or other coupling medium 4) and a relatively low acoustic absorption. One preferred material is low density polymethylpentene, but other polymers such as polypropylene, polystyrene, poly(ethylene teraphthalte) ("PET"), polyimide, and other rigid and flexible polymers may be used. If the window 11 is formed from a thin film material, the film may be a laminate to facilitate thermal bonding to the chamber 10, and/or may have a thickness of about 0.25 mm. For example, the window 11 may be sealingly attached to the chamber 10 using heat sealing, adhesives, mechanical clamps, or other fasteners, or other arrangements, or may be sealed using common gaskets or O-ring concepts. Thicker, more rigid materials may also be employed for the window 11.

The chamber 10 may include a wall with an inner surface that defines the internal volume 12. In one aspect of the invention, the wall may have an outer surface that is substantially surrounded by a gas (such as air) or another material that has an acoustic impedance that is significantly different from an acoustic impedance of the chamber wall and/or the sample material. The chamber wall may be made relatively thin, e.g., having a thickness of about 0.010 inches, and may be substantially acoustically transparent. Thus, an interface between the gas (or other material) around the outer surface of the chamber wall and the chamber wall itself may function to reflect acoustic energy back into the internal volume 12. In one embodiment, acoustic energy in the internal volume 12 may be reflected by the chamber wall/gas interface so as to create a secondary focal zone 618 of acoustic energy. This secondary focal zone 618 may be coincident with the focal zone 617, or may be located apart from the focal zone 617. Moreover, secondary focal zone 618 may be smaller than, larger or the same size as the focal zone 617, and the chamber wall may be arranged to create two or more secondary focal zones 618. Alternatively, the secondary focal zone may be shaped to act on a larger volume of material, thus creating a higher integrated pressure across that region of material. If focused, the secondary focal zone 618 may have an acoustic energy intensity that is higher (or lower) in relation to the acoustic energy intensity at the focal zone 617. For example, if a peak positive pressure at the focal zone 617 is about 1 MPa (mega Pascal) to about 10 MPa pressure, or about 150 PSI (pounds per square inch) to about 1,500 PSI, the peak positive pressure at the secondary focal zone 618 may be 20% greater than this. (A focal zone is an area in which the acoustic energy intensity is within about 6 dB of the peak acoustic intensity.) In this illustrative embodiment, the chamber wall includes a dome-like shape that is located near a top of the chamber 10, e.g., a portion farthest away from the acoustic energy source 2. This arrangement has been found to suitably reflect and focus acoustic energy to form a single secondary focal zone 618 that is located above the focal zone 617, and can help ensure that sample material is suitably exposed to acoustic energy, e.g., by inducing mixing in the chamber 10 or through other affects.

To help acoustically couple the chamber 10 with the acoustic energy source 2, the window 11 may be placed into contact with the coupling medium 4, whether the coupling medium 4 is liquid or solid. Where the coupling medium 4 is liquid, accommodations may be made to help maintain a gas/chamber wall interface by preventing the coupling medium 4 from contacting portions of the chamber 10 above the window 11. In this illustrative embodiment, the chamber 10 is received in a housing 615, such as a cylindrical sleeve, so that the window 11 is exposed at a lower end of the housing 615, but other portions of the chamber 10 are located in the inner space of the housing 615. For example, the window 11 may be bonded or otherwise attached to the housing 615 so as to form a liquid-tight joint that prevents liquid coupling medium 4 from flowing into the space between the chamber wall and the housing 615. This helps to maintain air or other gas around the chamber wall even if the window 11 and/or portions of the housing 615 are submerged below the top level of the coupling medium 4. That is, at least some parts of the chamber wall, such as the entire chamber 10, may be located below the top surface of the liquid coupling medium 4 while the gas/chamber wall interface is maintained. In FIG. 24, only a lower part of the chamber 10 is positioned below the top surface of the coupling medium 4, but it should be understood that the top level of the coupling medium 4 may be positioned in any suitable way relative to the chamber 10.

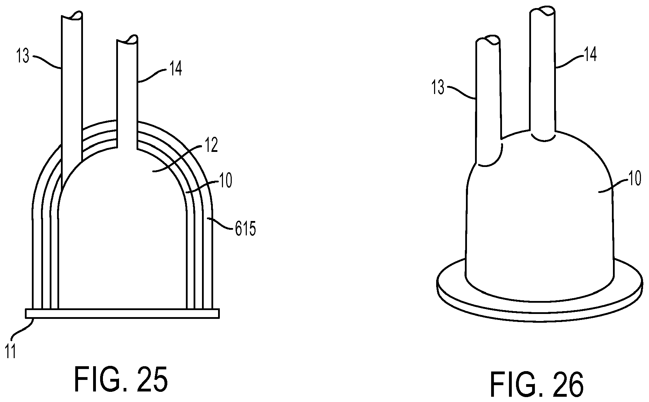

Of course, the arrangement in FIG. 24 is only one illustrative embodiment, and other configurations for the chamber 10 and housing 615 are possible. For example, FIG. 25 shows an arrangement in which the chamber 10 is configured like that in FIG. 24 (with the chamber having a wall with a dome-like shape). However, the housing 615 in this embodiment has a shape that generally conforms to that of the chamber 10 while substantially maintaining an air or other gas gap between the chamber 10 and the housing 615. The air gap need not be particularly large, and although the gap can vary in thickness, in some embodiments may be as thin as about 1mm. Note that the housing 615 and the chamber 10 may contact each other or be effectively attached, e.g., at areas near the inlet 13 and outlet 14, while still maintaining a condition in which the chamber wall is substantially surrounded by air or other gas.

The inlet 13 and outlet 14 may be arranged in a variety of ways, and in this embodiment the inlet 13 and outlet 14 each include a conduit (such as a flexible tubing) coupled to the chamber 10. The inlet 13 and/or outlet 14 may be provided with fittings (such as quick-connect fittings, luer-type fittings) or other suitable arrangement for making a fluid-tight connection to a sample material supply or receiver. The sample material supply may include, for example, a reservoir of sample material, conduits, pumps, filters, and/or any other suitable components. For example, in one embodiment, the inlet 13 and/or outlet 14 may include a flexible tubing that can interact with a peristaltic pump that causes sample material to flow through the chamber 10. In some embodiments, the inlet and/or outlet may include a check valve, one-way valve, electronically-controlled valves or other arrangement that helps to ensure that flow occurs in a desired way, e.g., so the flow of material is always from the inlet to the outlet even though flow may be intermittent. In some cases, acoustic processing of the sample material may cause the release of gas from the sample material which may interfere with acoustic processing. In this embodiment, the outlet 14 is located at an uppermost portion of the chamber 10 so that any gas in the internal volume 12 may be removed with flow of sample material out of the internal volume 12 and into the outlet 14. However, other arrangements are possible, such as a gas trap, vent, gas scavenger, or other configuration to reduce the presence of gas in the internal volume 12. The inlet 13 and/or outlet 14 (as well as other components including the chamber 10, window 11 and housing 615) may be made sterilizable (e.g., by ethylene oxide, gamma radiation, autoclaving, chemical treatment, etc.) so that a user can be ensured that sample material will not be contaminated. Also, such components can be made and intended for a single use, and subsequently discarded or refurbished.

A portion of the chamber 10, such as an upper portion of the chamber 10, may include an inspection window or other arrangement that permits visible light inspection of the internal volume 12. Such inspection may be done by a human, or by a suitably arranged sensor 21 (see FIG. 24) such as a video camera, photodetector, IR detector, and so on. Characteristics of the material in the internal volume 12 detected by the sensor 21 may be used by the controller 20 to control the acoustic energy source 2 or other components of the system 1. For example, if excessive cavitation is to be avoided, the controller 20 may adjust the acoustic energy at the focal zone 617 if the sensor 21 detects the presence of cavitation bubbles of a certain size and/or number. Other features may be detected by the sensor 21, such as the size, density or other characteristics of particles in the chamber 10 in the case where the acoustic treatment is intended to break down the size of particles in the sample material. Thus, the sensor 21 may detect whether acoustic treatment is progressing as desired and whether processing is complete, e.g., to trigger the introduction of additional sample material into the chamber 10. Like the window 11, the inspection window may be formed of any suitable material, such as glass, sapphire, quartz, and/or polymer materials, and/or may be part of the chamber wall. Also, the sensor 21 may be made part of the housing 615 (e.g., attached to a wall of the housing 615) so that when the housing 615 and chamber 10 are placed in service, the sensor 21 may be suitably arranged to detect conditions in the internal volume 12 without any adjustment or other configuration of the sensor 21 being required. A communications and/or power connection of the sensor 21 with the controller 20 may be established wirelessly, or by wire, such as by an electrical connector on the housing 615 contacting a counterpart connector when the housing 615 is mounted to a holder. That is, an acoustic treatment machine that includes the acoustic energy source 2, a container 3 for the coupling medium 4, the controller 20, etc. (e.g., like a Model S2 or Model S220 acoustic treatment machine offered by Covaris, Inc. of Woburn, MA) may also include a holder or other mounting arrangement to physically engage with the housing 615 and hold the chamber 10 is a proper position in relation to the coupling medium 4 and/or the acoustic energy source 2. In one embodiment, the holder may include a cylindrical opening that receives a cylindrical portion of the housing 615 and supports the housing 615 in a desired location. The holder and the housing 15 may be fixed relative to each other using a clamp, a set screw, friction fit, or other suitable arrangement.

The body of the chamber 10 may be made of any material or combination of materials suitable to contain the sample in the internal volume 12 during treatment, to act as an environmental seal, and/or to provide an acoustic reflection function. In some embodiments, the chamber 10 may be made of a rigid or flexible material, such as a thermally conductive metal or polymer, or a combination of such materials. Preferably, the material used for the chamber 10 has a low acoustic absorption. In certain embodiments, the upper portion of the chamber 10 (e.g., including an inspection window) can be arranged to reflect acoustic energy back into the internal volume 12 (e.g., functioning with a gas interface), providing additional process efficiencies. If the chamber 10 is made from multiple parts, such as by upper and lower members, the members may be joined together by thermal bonding, adhesive bonding, external clamping, mechanical fasteners with an o-ring or other gasket to form a seal between the members, welding, and so on. If the bond is to be achieved by thermal bonding, the upper and lower members may be made of, or include, film laminates having heat bondable outer layers and heat resistant inner layers.

The internal volume 12 may be sized and shaped as appropriate for the sample material to be treated, e.g., some acoustic treatment applications (such as sterilization) may function more effectively if a relatively small volume of sample material is treated in a relatively small volume, whereas other applications (such as mixing) may produce better results using a larger volume for the internal volume 12. The internal volume 12 can have different shapes or other configuration characteristics, e.g., the internal volume 12 may be defined by vertical walls, can have a conical shape, can have a curved shape, and so on. Also, the chamber 10 can be made of multiple components such as an upper member and lower acoustically transparent member (e.g., window 11), and a body which together define the internal volume that contains the material to be treated. Alternately, the chamber 10 and window 11 may be made as a single unitary piece or in other ways.

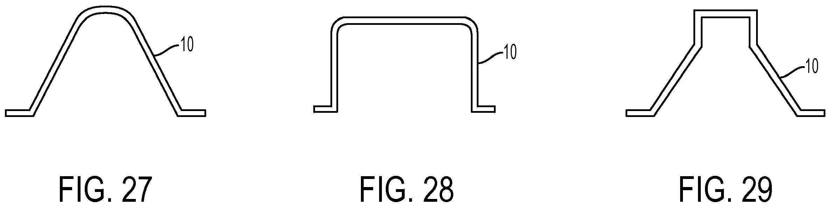

FIG. 26 shows a perspective view of the dome-shaped chamber 10 of the FIG. 24 embodiment. Although a curved dome shape with a hemispherical upper section has been found to be useful in creating a secondary focal zone, other dome shapes are possible. For example, FIG. 27 shows a cross sectional view of a chamber 10 having a substantially conical shape. Such an arrangement may be useful, for example, for focusing acoustic energy near the top of the chamber 10. FIG. 28 shows another illustrative embodiment in which the chamber 10 has an approximately cylindrical shape. This arrangement may be useful for generating multiple secondary focal zones, e.g., near the periphery of the upper portion of the chamber 10. FIG. 29 shows another illustrative embodiment in which the chamber has a lower portion with a conical shape and an upper portion with a cylindrical shape. This arrangement may help to create a secondary focal zone in a relatively confined area near the top of the chamber 10. Of course, the dome shapes of FIGs. 27-29 could be modified in other ways, e.g., including tetrahedron shapes, oval shapes, geodesic dome shapes, and other regular and irregular arrangements. Although these embodiments are shown without a window 11 or other similar arrangement, a window 11 may be provided at the lower opening of the chamber 10, e.g., by bonding a window 11 to the flange at the lower end of the chamber 10.

As discussed above and shown in FIG. 24, the acoustic treatment system 1 may include a container 603 that contains the acoustic energy source 2, the chamber 10, the coupling medium 4 and/or other components. The container 603 may take any suitable size, shape or other configuration, and may be made of any suitable material or combination of materials (such as metal, plastic, composites, etc.). Although in this illustrative embodiment the container 603 has a can-like configuration with an open top to permit access to the container 603, the container 603 may be arranged to have a lid or other closure. For example, the chamber 10, housing 615, etc., may be received in a hole in a lid that closes the container 603 so that the chamber 10 is suitably positioned at least partially inside the container 603. If the coupling material 4 is solid, the container 603 and the coupling medium 4 may be essentially integrated with each other, with the coupling medium 4 essentially functioning as an acoustic coupling as well as a physical attachment of the acoustic source 2 and the chamber 10 or a holder for the chamber 10.

### Cavitation Control

In some applications, it can be preferable to treat the sample with as much energy as possible without causing cavitation. This result can be achieved by suppressing cavitation. Cavitation can be suppressed by pressurizing the treatment chamber above ambient, often known as "overpressure," to the point at which no negative pressure develops during the rarefaction phase of the acoustic wave. This suppression of cavitation is beneficial in applications such as cell transformation where the desired effect is to open cellular membranes while maintaining viable cells. In other applications it may be desirable to enhance cavitation. In these applications, a "negative" overpressure or vacuum can be applied to the region of the focal zone.

The control of cavitation in the sample also can be important during acoustic treatment processes. In some scenarios, the presence of small amounts of cavitation may be desirable to enhance biochemical processes; however, when large numbers of cavitation bubbles exist they can scatter sound before it reaches the target, effectively shielding the sample.

Cavitation can be detected by a variety of methods, including acoustic and optical methods. An example of acoustic detection is a passive cavitation detector (PCD) which includes an external transducer that detects acoustic emissions from cavitation bubbles. (That is, the PCD may be external to the chamber 10, e.g., the PCD may be located in the coupling medium 4.) The signal from the PCD can be filtered, for example using a peak detector followed by a low pass filter, and then input to a controlling computer (part of controller 20) as a measure of cavitation activity. The acoustic signal could be adjusted in ways similar to those described in the temperature control example to maintain cavitation activity at a desired level.

Overpressure: Increased pressure in the chamber 10 is one technique for controlling cavitation. Overpressure tends to remove cavitation nuclei and increases the energy level required to create cavitation. Motes in the fluid are strongly affected by overpressure and so cavitation in free-fluid is often dramatically reduced, even by the addition of one atmosphere of overpressure. Nucleation sites on the chamber 10 walls tend to be more resistant to overpressure; however the cavitation tends to be restricted to these sites and any gas bubbles that float free into the free-fluid are quickly dissolved. By increasing the ambient pressure of the system, the pressures required for bubble nucleation and collapse increase, thus increasing the force imparted by collapse of the cavitation bubble. This relationship is roughly linear - that is, doubling the ambient pressure of the system doubles the resulting force of bubble collapse. Careful system design to accommodate higher overall pressures can allow this to scale by many factors. Overpressure may be applied to the treatment chamber, an array of treatment chambers, the treatment coupling medium and vessel, or to the entire system to achieve a higher than atmospheric pressure in the region of the focal zone.

Degassing: Reducing the gas content of the material fluid tends to reduce cavitation, again by reducing cavitation nuclei and making it harder to initiate cavitation. Another method of controlling cavitation or the effects of cavitation is to control the gasses that are dissolved in the sample fluid. For instance, cavitation causes less mechanical damage in fluid saturated with helium gas than in fluid saturated with argon gas.

### Monitoring of Cavitation

A variety of methods may be employed to detect cavitation. For example, acoustic emissions, optical scattering, high-speed photography, mechanical damage, and sonochemicals can be used. As described above for monitoring temperature, information from cavitation detection can be used by the system to produce an output that selectively controls exposure of a sample to sonic energy in response to the information. Each of these methods to monitor cavitation are described more fully below.

Acoustic emissions: Bubbles are effective scatterers of ultrasound. The pulsation mode of a bubble is referred to as monopole source, which is an effective acoustic source. For small, generally linear oscillations, the bubble simply scatters the incident acoustic pulse. However, as the response becomes more nonlinear, it also starts to emit signals at higher harmonics. When driven harder, the bubbles start to generate subharmonics as well. Eventually as the response becomes a periodic or chaotic, the scattered field tends towards white noise. In the scenario where inertial collapses occur, short acoustic pressure pulses are emitted. An acoustic transducer can be configured to detect these emissions. There is a detectable correlation between the onset of the emissions and cell disruption.

Optical scattering: Bubbles also scatter light. When bubbles are present, light is scattered. Light can normally be introduced into the system using fiber optic light sources so that cavitation can be detected in real-time, and therefore can be controlled by electronic and computer systems.

High-speed photography: Bubbles can be photographed. This method typically requires high-speed cameras and high intensity lighting, because the bubbles respond on the time frame of the acoustics. It also requires good optical access to the sample under study. This method can give detailed and accurate data and may be a consideration when designing systems according to the invention. Stroboscopic systems, which take images far less frequently, can often give similar qualitative performance more cheaply and easily than high-speed photography.

Mechanical damage: Cavitation is known to create damage to mechanical systems. Pitting of metal foils is a particularly common effect, and detection method. There is a correlation between the cavitation needed to pit foils and to disrupt cells.

Sonochemicals: A number of chemicals are known to be produced in response to cavitation. The yield of these chemicals can be used as a measure of cavitational activity. A common technique is to monitor light generation from chemicals, such as luminol, that generate light when exposed to cavitation. Sonochemical yield usually can not be done during cell experiments but can be done independently under identical conditions, and thereby, provide a calibrated standard.

### Materials for Treatment

### A. Biological Materials

Many biological materials can be treated according the present invention. For example, such materials for treatment include, without limitation, growing plant tissue such as root tips, meristem, and callus, bone, yeast and other microorganisms with tough cell walls, bacterial cells and/or cultures on agar plates or in growth media, stem or blood cells, hybridomas and other cells from immortalized cell lines, and embryos. Additionally, other biological materials, such as serum and protein preparations, can be treated with the processes of the invention, including sterilization.

### B. Binding Materials

Many binding reactions can be enhanced with treatments according to the invention. Binding reactions involve binding together two or more molecules, for example, two nucleic acid molecules, by hybridization or other non-covalent binding. Binding reactions are found, for example, in an assay to detect binding, such as a specific staining reaction, in a reaction such as the polymerase chain reaction where one nucleotide molecule is a primer and the other is a substrate molecule to be replicated, or in a binding interaction involving an antibody and the molecule it binds, such as an immunoassay. Reactions also can involve binding of a substrate and a ligand. For example, a substrate such as an antibody or receptor can be immobilized on a support surface, for use in purification or separation techniques of epitopes, ligands, and other molecules.

### C. Chemical and Mineral Materials

Organic and inorganic materials can be treated with controlled acoustic pulses according to the methods of the invention. The sonic pulses may be used to commute a solid material, particularly under a feedback control regime, or in arrays of multiple samples. As with biological samples, individual organic and inorganic samples in an array can be treated in substantial isolation from the laboratory environment. Beside altering their physical integrity, materials can be dissolved in solvent fluids, such as liquids and gasses, or extracted with solvents. For example, dissolution of polymers in solvents can be very slow without stirring, but stirring multiple samples with current methods is difficult and raises the possibility of cross-contamination between samples. However, stirring of multiple samples without cross-contamination between samples can be accomplished with apparatus and methods of the present invention.

### Treatment Applications

### A. Altering Cell Accessibility

Sonicators can disrupt cells using frequencies around 20 kHz. It is generally thought there are two ways in which ultrasound can affect cells, namely by heating and by cavitation, which is the interaction of the sound wave with small gas bubbles in the sample. Heating occurs primarily due to absorption of the sound energy by the medium or by the container. For dilute aqueous systems, it is absorption by the container that is a main source of the heating. Heating is not desirable in some treatment applications, as described herein. The heating associated with the compression and cooling associated with the rarefaction of a sound wave is relatively small, even for intense sound.

According to the invention, controlled sonic pulses in a medium are used to treat a sample containing biological material. The pulses can be specifically adapted to preferentially interact with supporting matrices in a biological material, such as plant cell walls or extracellular matrices such as bone or collagen, thereby lessening or removing a barrier function of such matrices and facilitating the insertion of extracellular components into a cell. In this application, the cell is minimally altered and cell viability is preserved. These pulses can be caused by shock waves or by sound waves. The waves can be created external to the sample, or directly in the sample, via applied mechanical devices. In experiments where thermal effects are negligible, there typically is no lysis, unless cavitation is present. Other modes of sonic energy can have different effects than disrupting a matrix and can be used either with pre-treatment, with disrupting sonic energy, or by themselves. For, example the conditions to disrupt a matrix can be different from those to permeabilize a cell membrane.

There are many possible mechanisms by which cavitation may affect cells and there is no consensus as to which mechanisms, if any, dominate. The principle mechanisms are thought to include shear, microjets, shock waves, sonochemistry, and other mechanisms.

### B. Extracting

In a variation of the method to alter cellular accessibility described above, controlled pulses in a medium can be used to treat a sample containing biological material to extract a fraction or fractions of the biological material. The pulses are specifically adapted to preferentially interact with supporting matrices, such as plant cell walls or extracellular matrices such as bone or collagen, or materials having differences in rigidity or permeability in a biological material, thereby lessening or removing a barrier function of such matrices or materials. These pulses can be caused by shock waves or by sound waves. The waves can be created external to the sample, or directly in the sample, via applied mechanical means.

The supporting matrix of a biological sample can be disrupted without disrupting one or more selected internal structures of the cells contained within the matrix. Representative examples of such samples are: i) bone, in which a rigid matrix contains living cells of interest; ii) mammalian tissue samples, which contain living cells embedded in a matrix of elastic connective tissue and "glycocalyx" or intercellular matrix; and iii) plant tissues, such as leaves, which contain cells in a matrix of cellulose, often crosslinked with other materials, of moderate rigidity. Virtually all living cells are gelatinous in texture, and can be deformed to some extent without rupture or internal damage. Matrices, in contrast, are designed to support and protect cells, as well as to achieve other biological functions. In the three examples above, the matrices of bone and leaves are designed to provide rigidity to the structure, while the support of most collagenous matrices has a strongly elastic character. Thus, different protocols for example, amplitude, duration, number of pulses, and temperature of sample, may be used to disrupt different matrices by mechanical means without damaging the cellular material.

Three areas to optimize for extraction are treatment waveform, mixing waveform, and positioning or dithering. One method to determine the appropriate treatment and positioning parameters for a target sample for extraction purposes is described below.

First, a solid sample is placed in a volume of liquid in about a 1:1 ratio (weight/volume), in a treatment chamber. For example, 0.25 ml of methanol is added to 0.25 gm of leaf tissue in a 0.5 ml treatment chamber. A single sample is placed within the focal zone of the sonic apparatus. Without using the treatment protocol, the mixing waveform is adjusted to provide "stirring" of the sample at the lowest amplitude, fewest cycles/burst, and lowest duty cycle. After the mixing waveform protocol is defined, the disruption treatment waveform is adjusted by immobilizing the target sample in the focal zone such that there is no mixing and no sample movement, such as dithering. Using a sonic energy source such as a piezoelectric transducer, the sample is subjected to a minimum number of cycles per burst, for example, three. For extraction purposes, the amplitude is initially used with a nominal 500 mV setting. A portion of the sample is treated and inspected under a microscope for signs of membrane disruption. Such inspection can be done in conjunction with dyes that stain intracellular organelles. The number of cycles/burst is then increased until a particular desired tissue disruption level is achieved in the immobilized portion of tissue. With a fresh sample, and with a 1:1 ratio of tissue to liquid, the temperature of the sample is monitored during a million cycle total treatment with an infra-red sensor directed to the top of a thin polyethylene film covering the sample vessel. The duty cycle is adjusted to keep the temperature within predefined ranges, such as 4 degrees C. within +/-2 degrees C. As discussed above, the different phases of extraction can be performed with different treatment chambers arranged in series (as in FIG. 23) or with the same chamber (e.g., where material flows in an oscillating manner through the chamber 10). The different chambers, or treatment conditions, may be adjusted to achieve the desired result for each stage in the process.

### C. Introducing a Molecule into or Removing a Molecule from a Cell

Once a sample having a matrix has been sufficiently weakened or attenuated, but not to the point where a substantial number of cells contained within the matrix are killed or lysed, an exposed target cell or cells become amenable to insertion of exogenous molecules by techniques such as transfection or transformation. With some matrices, it may be convenient to isolate the cells from the matrices and then to transfect the cells. In other cases, it will be preferable, particularly in an automated system, to perform the transfection directly on the treated tissue sample, using solutions and conditions adapted from known techniques. Alternatively, in situations where a cell to be treated is not situated within a matrix, the cell can be directly treated according to the process below without having to pre-treat the matrix. While the treatment below is described mainly for transfection, methods and apparatus according to the present invention are equally applicable to a transformation process or other processes to introduce an exogenous material into a permeabilized cell membrane.

The waveforms used to alter the permeability of a cell are refined depending on the particular application. Typically, the shock wave is characterized by a rapid shock front with a positive peak pressure, for example about 100 MPa, and a negative peak pressure, for example about negative 10 MPa. This waveform is of a few microsecond duration, on the order of about 5 microseconds. If the negative peak is greater than about 1 MPa, cavitation bubbles may form. Cavitation bubble formation is also dependent upon the surrounding medium. For example, glycerol is a cavitation inhibitive medium; whereas, liquid water is a cavitation promotive medium. The collapse of cavitation bubbles forms "microjets" and turbulence that impinge on the surrounding material.

Sound waves, namely acoustic waves at intensities below the shock threshold, provide an alternative means of disrupting the matrix to allow access to the plasma membranes of the cells to allow transformation. Such sound waves can be generated by any known process. As biological material is subjected to subzero temperatures, for example about negative 5 degrees C, most but not all of the water is in the solid phase. However, in certain biological tissues microdomains of liquid water still remain for several reasons, such as natural "antifreeze" molecules or regions of higher salt concentration. Therefore, as a sample temperature is varied during the treatment with sound or shock waves, microdomains of liquid water are able to form shock waves and induce cavitation bubble formation and collapse, with the resultant shear stresses that impinge on surrounding tissues. Indeed, gradual alteration of the sample temperature can be desirable, as it provides focused domains of liquid water for impingement on the surrounding material. The waves can be applied to the samples either directly, as piezoelectric pulses, or via an intervening medium. This medium may be water, buffer, stabilizing medium for the target material to be isolated, or extraction medium for the target. An intervening medium also can be a solid, formed of a material which is intrinsically solid, or of a frozen solution.

At that point, or, optionally, previously, a solution or suspension containing the material to be incorporated into the cells is added to the sample. In one embodiment, the exogenous material is incorporated into the cells in a conventional manner, as is known in the art for cells with exposed plasma membranes. In another embodiment, acoustic energy is used to transiently permeabilize a plasma membrane to facilitate introduction of exogenous materials into the cells. The exogenous material may be present in the sample during the weakening of the matrix by acoustic energy. Even when the cells remain intact, as determined by dye exclusion or other viability measurements, the process of weakening the cell matrix by acoustic energy transiently destabilizes the plasma membranes, increasing the uptake of exogenous macromolecules and structures. If a further increase in the rate of incorporation is needed, then the intensity or time of application of acoustic energy is slightly increased until the cell membrane becomes transiently permeable. For example, a gentle pulse or wave is applied to the mixture, with a predetermined amplitude. This amplitude can be determined readily in separate experiments on samples of the same type to transiently make a plasma membrane of a cell type porous, in a similar empirical manner to the steps described above for determining an appropriate treatment to disrupt a matrix. During the transient porous state, exogenous materials diffuse into the cell and the materials are trapped there once the sonic or shock pulse is removed.

A major advantage of these methods for transfection, or other incorporation of exogenous material into living cells, is that the methods are readily amenable to scale-up, to automation, and to marked reduction in sample size and reagent volume. Thus, the methods are adaptable to large scale automation, in large part because they do not require the isolation of the cells from their matrix. Additionally, these methods are amenable to a continuous flow process such as those described herein. For example, the sonic energy treatment can be different for permeabilization than for sterilization, but the sample to be treated can be flowed through an apparatus similar to that described in FIG. 21.

The number of cells per ml of media is also important factor for cellular applications to use acoustics effectively the concentration of the cells should not be too low (as the energy generated and utilized depends on the concentration of cells) or too high (viscosity is high). Additionally, with the process of permeabilization and with the mixing profile, other techniques of gene transfer may be augmented. Examples include, calcium phosphate coprecipitation, electroporation, and receptor-dependent processes.

### D. Sterilizing

The terms "sterilize," "disinfect," "preserve," decontaminate," "inactivation," "disinfect," and "kill" are used interchangeably herein, unless otherwise demanded by the context. "Sterilization," namely killing of all organisms, may not be synonymous in certain operations with "decontamination," for example, when the contaminant is non-living, such as a protein or prion. These terms, typically, mean the substantial elimination of or interference with any activity of a particular organism and/or particle.

Methods for permeabilization and extraction, described above, can be modified to sterilize a sample. The apparatus and methods for sterilizing can be optimized for efficient sterilization of particular materials in particular volumes and containers. For a particular material to be sterilized, an initial set of conditions is selected. Such conditions can include selection of a type of sonic pulse generator, intensity of sonic energy, frequency of sonic energy, where relevant, and/or like variables. The conditions also can include volume, mode of transport, and/or exposure of the materials to be sterilized. Then, the initial conditions and near variants are applied to the sample, and the percentage of cells or viruses killed is determined by standard assay conditions. Further variables are selected for change. Accordingly, a zone of maximal killing of the test organism is found. Finally, other variables, such as flow rate and/or length and/or intensity of sonic exposure, are optimized to provide both a technical solution and a commercially useful solution to the problem of sterilizing a particular material. Any of these empirically determined values can be programmed into a control system of an apparatus used for sterilization to actively control sterilization, or the apparatus can have these values previously determined such that a user need only select a predetermined sterilization mode an the apparatus.

For many liquids, adequate sterilization is provided by destroying the cell walls of bacteria, fungi, and other living cells. This result is accomplished by using frequencies and wavelengths of sound which preferentially excite the membranes of the cells while minimally heating the solution until the cells are lysed. In most cellular organisms, opening the membrane and allowing the contents to mix with an extracellular fluid will kill the organism.

Viruses can be opened to the solution by similar processing. In the case of viruses, exposure of their internal nucleic acid to the solution may not be adequate to completely inactivate them, since the naked DNA or RNA can also be infectious. Adjuncts such as iodine or nucleic-acid digesting enzymes in the solution can be provided to complete the inactivation of the viruses.

### E. Mixing, Stirring, and Heating

In fluid samples, including powdered and granular media and gasses, sample mixing is conventionally performed by vortexing or stirring, or other methods such as inversion of a sample containing an air space, and shaking. Vortexing is essentially achieved by mechanical motion of the entire vessel while stirring involves mechanical contact of a driven device with a fluid. Stirring is accomplished with a variety of devices, for example with propellers, impellers, paddles, and magnetic stir bars. One problem with these methods is that it is difficult to increase their scale in order to handle dozens or hundreds of sample vessels at once. Another problem with these methods is the difficulty of mixing multiple samples while keeping the each sample substantially free from contamination. As described in more detail below, methods according to the invention can use sonic energy to mix a sample while avoiding problems with contamination. Factors, such as focusing the sonic energy, as well as otherwise controlling an acoustic waveform of the sonic energy, can be used to selectively mix a sample, for example, through acoustic streaming and/or micro streaming.

A fluid sample can be mixed controllably using the systems described herein. No direct contact between the material to be mixed and the sonic energy source is required. When the material to be mixed is in a treatment chamber, the treatment chamber itself is not necessarily touched by the source and is typically coupled to the source by a coupling medium.

### F. Enhancing Reactions and Separations

In certain embodiments, temperature, mixing, or both can be controlled with ultrasonic energy to enhance a chemical reaction. For example, the association rate between a ligand present in a sample to be treated and an exogenously supplied binding partner can be accelerated. In another example, an assay is performed where temperature is maintained and mixing is increased to improve association of two or more molecules compared to ambient conditions. It is possible to combine the various aspects of the process described herein by first subjecting a mixture to heat and mixing in order to separate a ligand or analyte in the mixture from endogenous binding partners in the mixture. The temperature, mixing, or both, are changed from the initial condition to enhance ligand complex formation with an exogenously supplied binding partner relative to ligand/endogenous binding partner complex formation at ambient temperature and mixing. Generally, the second temperature and/or mixing conditions are intermediate between ambient conditions and the conditions used in the first separating step above. At the second temperature and mixing condition, the separated ligand is reacted with the exogenously supplied binding partner.

### Polymerase Chain Reaction ("PCR") Thermal Cycling

One of the bottlenecks of the PCR technique is cooling time. The heating cycle is rapid; however, cooling is limited by convection. Even in biochip formats, in which DNA or another target molecule is immobilized in an array on a microdevice, there is no "active" cooling process. However, certain embodiments of the invention can be used to overcome this bottleneck.

In certain embodiments, a treatment process can be used to both heat and cool the sample rapidly with little overshoot from a baseline temperature at which the primer and target to be amplified anneal. The process can be summarized as follows. A sample is treated with relatively high power sonic energy such that the sample absorbs sonic energy and is heated. Then, the sample is mixed at low power to cool the sample by forcing convection, which may be accomplished in conjunction with a cool water bath. The heating and cooling steps can be performed in the same chamber 10, or alternately in separate chambers 10, e.g., in a system like that in FIG. 23. The material can be controlled by the timing of the transfer mechanism, such as the pump, to allow discrete processing times 'in chamber' before discharging the material and bringing in new material. This can provide time for process steps such as processing, mixing, cooling and others to fully develop before introducing new unprocessed sample to the chamber.

### G. Purification, Separation, and Reaction Control

Focused sonic fields can be used to enhance separations. As noted elsewhere, sonic foci can be used to diminish or eliminate wall effects in fluid flow, which is an important element of many separation processes, such as chromatography including gas chromatography, size exclusion chromatography, ion exchange chromatography, and other known forms, including filed-flow fractionation. The ability to remotely modulate and/or reduce or eliminate the velocity and concentration gradients of a flowing stream is applicable in a wide variety of situations.

Sonic fields also can be used to minimize concentration polarization in membrane processes, including particle classification, filtration of fine particles and colloids, ultrafiltration, reverse osmosis, and similar processes. Concentration polarization is the result of the tendency of filtered material to be present at high concentration in a layer on the filter. This layer has a low fluid concentration and, thus, diminishes the rate of filtration as the filtered solution becomes more concentrated, or as the layer thickens. This layer can be stirred remotely by focused sonic energy of low to moderate intensity. Flow rate, thus, can be enhanced without significant cost in energy or membrane life.

H. Further Uses for Remotely Actuated and Controlled Solution Mixing with Sonic Energy

Control of sonic energy emission, sonic energy characteristics, and/or location of a target relative to sonic energy also can be used to pump and control the flow rate of liquids, especially in capillaries; enhance chemical reactions, such as enhancing second-order reaction rates; increase effective Reynolds number in fluid flow; and control the dispensing of semi-solid substances.

By focusing sonic energy and positioning it near a wall of a chamber or another discontinuity in a fluid path, many local differences in the distribution of materials within a sample and/or spatially-derived reaction barriers, particularly in reactive and flowing systems, can be reduced to the minimum delays required for microscopic diffusion. Put differently, enhanced mixing can be obtained in situations where imperfect mixing is common.

The controller 20 may include any suitable components to perform desired control, communication and/or other functions as described above. For example, the controller 20 may include one or more general purpose computers, a network of computers, one or more microprocessors, etc., for performing data processing functions, one or more memories for storing data and/or operating instructions (e.g., including volatile and/or non-volatile memories such as optical disks and disk drives, semiconductor memory, magnetic tape or disk memories, and so on), communication buses or other communication devices for wired or wireless communication (e.g., including various wires, switches, connectors, Ethernet communication devices, WLAN communication devices, and so on), software or other computer-executable instructions (e.g., including instructions for carrying out functions related to controlling the acoustic energy source 2, a pump 33, etc., as described above and other components), a power supply or other power source (such as a plug for mating with an electrical outlet, batteries, transformers, etc.), relays and/or other switching devices, mechanical linkages, one or more sensors or data input devices (such as a sensor to detect a temperature and/or presence of the material in a chamber 10, a video camera or other imaging device to capture and analyze image information regarding the chamber 10 or other components, position sensors to indicate positions of the acoustic transducer 2 and/or the vessel 10, and so on), user data input devices (such as buttons, dials, knobs, a keyboard, a touch screen or other), information display devices (such as an LCD display, indicator lights, a printer, etc.), and/or other components for providing desired input/output and control functions.

It is to be understood that the invention is not limited in its application to the details of construction and the arrangement of components set forth in the following description or illustrated in the drawings. Other embodiments and manners of carrying out the invention are possible. The phraseology and terminology used herein is for the purpose of description and should not be regarded as limiting. The use of "including," "comprising," or "having" and variations thereof is meant to encompass the items listed thereafter and equivalents thereof as well as additional items. Having thus described various illustrative embodiments and aspects thereof, modifications and alterations may be apparent to those of skill in the art. Such modifications and alterations are intended to be included in this disclosure, which is for the purpose of illustration only, and is not intended to be limiting. The scope of the invention should be determined from proper construction of the appended claims, and their equivalents.

What is claimed is:

## Claims

1. A method of preparing a nanocrystalline composition, comprising:
providing at least a portion of a sample comprising a volume of greater than 30 mL in a vessel;
transmitting focused acoustic energy greater than 1000 cycles per burst having a frequency of between about 100 kilohertz and about 100 megahertz and a focal zone having a size dimension of less than about 2 centimeters through a wall of the vessel such that the at least a portion of the sample is disposed in the focal zone; and
forming, through crystal growth, a plurality of crystalline particles in the sample having an average size of greater than about 10 nm and a polydispersity index of less than 1.0 as calculated according to the International Standard on dynamic light scattering ISO 13321, by, at least in part, exposure of the sample to the focal zone.

2. The method of claim 1, wherein transmitting focused acoustic energy such that the sample is disposed at least partially in the focal zone comprises transmitting the focused acoustic energy at between 1000 cycles per burst and 6000 cycles per burst, or greater than 6000 cycles per burst.

3. The method of one of the preceding claims, wherein the sample is exposed to the focal zone for less than 1 hour.

4. The method of one of the preceding claims, wherein the plurality of crystalline particles in the sample have an average size of between about 10 nm and about 1 micron.

5. The method of one of the preceding claims, wherein the polydispersity index of the plurality of crystalline particles in the sample, as calculated according to the International Standard on dynamic light scattering ISO 13321, is between about 0.03 and about 0.1, or has a relative standard deviation of less than 1% of an average particle size of the plurality of crystalline particles.

6. The method of one of the preceding claims, further comprising causing flow of a portion of the sample through at least one process chamber of the vessel such that the sample is exposed to the focal zone while disposed in the at least one process chamber.

7. The method of claim 6, wherein the at least one process chamber includes an inlet and an outlet arranged such that the sample is exposed to the focal zone while disposed in the at least one process chamber.

8. The method of claim 6 or 7, wherein causing flow of a portion of the sample through the at least one process chamber comprises causing flow of the portion of the sample through the inlet and the outlet of the at least one process chamber and exposing the sample to the focal zone multiple times.

9. The method of one of claims 6 or 8, wherein causing flow of a portion of the sample in the vessel comprises causing flow of the portion of the sample through the vessel at a rate of at least 0.1 mL/min, or between about 0.5 mL/min and about 100 mL/min.

10. The method of one of the preceding claims, wherein the sample includes a bioactive agent.

11. The method of one of the preceding claims, wherein transmitting focused acoustic energy such that the sample is disposed at least partially in the focal zone comprises transmitting the focused acoustic energy at a power of between 50 Watts and 300 Watts.

12. The method of one of the preceding claims, further comprising maintaining a temperature of the sample within a predetermined range during acoustic energy treatment.

13. The method of one of the preceding claims, further comprising circulating a thermal transfer medium around a wall of the vessel in a volume defined by a jacket surrounding at least a portion of the vessel.

14. The method of one of the preceding claims, wherein transmitting focused acoustic energy through the wall of the vessel comprises transmitting the acoustic energy from an acoustic energy source to the vessel through a coupling medium and controlling the temperature of the coupling medium.

15. The method of one of the preceding claims, further comprising recirculating the coupling medium to and from the vessel and through a chiller or heater adapted to adjust a temperature of the coupling medium.

16. The method of one of the preceding claims, further comprising subjecting the sample to pressurization such that a pressure within the vessel is greater than a pressure outside of the vessel.

17. The method of one of the preceding claims, wherein transmitting focused acoustic energy includes a duty cycle of 50%.

## Patentansprüche

1. Verfahren zur Herstellung einer nanokristallinen Zusammensetzung, umfassend:
Bereitstellen mindestens eines Teils einer Probe, die ein Volumen von größer als 30 mL umfasst, in einem Gefäß;
Übertragen fokussierter akustischer Energie mit mehr als 1000 Zyklen pro Stoß, die eine Frequenz zwischen etwa 100 Kilohertz und etwa 100 Megahertz und einen Fokalbereich mit einer Größendimension von weniger als etwa 2 Zentimetern aufweist, durch eine Wand des Gefäßes, sodass der mindestens eine Teil der Probe in dem Fokalbereich liegt; und
Bilden, durch Kristallwachstum, einer Vielzahl kristalliner Partikel in der Probe, die eine mittlere Größe von größer als etwa 10 nm und einen Polydispersitätsindex von weniger als 1,0 aufweisen, berechnet gemäß des internationalen Standards zur Dynamischen Lichtstreuung ISO 13321, indem die Probe, zumindest teilweise, dem Fokalbereich ausgesetzt wird.

2. Verfahren gemäß Anspruch 1, wobei das Übertragen fokussierter akustischer Energie, sodass die Probe mindestens teilweise im Fokalbereich liegt, das Übertragen fokussierter akustischer Energie mit zwischen 1000 Zyklen pro Stoß und 6000 Zyklen pro Stoß oder mehr als 6000 Zyklen pro Stoß umfasst.

3. Verfahren gemäß einem der vorangegangenen Ansprüche, wobei die Probe dem Fokalbereich für weniger als 1 Stunde ausgesetzt wird.

4. Verfahren gemäß einem der vorangegangenen Ansprüche, wobei die Vielzahl kristalliner Partikel in der Probe eine mittlere Größe von zwischen etwa 10 nm und etwa 1 µm aufweist.

5. Verfahren gemäß einem der vorangegangenen Ansprüche, wobei der Polydispersitätsindex der Vielzahl kristalliner Partikel in der Probe, berechnet gemäß des internationalen Standards zur Dynamischen Lichtstreuung ISO 13321, zwischen etwa 0,03 und etwa 0,1 liegt oder eine relative Standardabweichung von weniger als 1% bezogen auf die mittlere Partikelgröße der Vielzahl kristalliner Partikel aufweist.

6. Verfahren gemäß einem der vorangegangenen Ansprüche, das zusätzlich das Fließenlassen eines Teils der Probe durch mindestens eine Prozesskammer des Gefäßes umfasst, sodass die Probe dem Fokalbereich ausgesetzt ist, während sie sich in der mindestens einen Prozesskammer befindet.

7. Verfahren gemäß Anspruch 6, wobei die mindestens eine Prozesskammer einen Einlass und einen Auslass enthält, die derart angeordnet sind, dass die Probe dem Fokalbereich ausgesetzt ist, während sie sich in der mindestens einen Prozesskammer befindet.

8. Verfahren gemäß Anspruch 6 oder 7, wobei das Fließenlassen eines Teils der Probe durch die mindestens eine Prozesskammer das Fließenlassen des Teils der Probe durch den Einlass und den Auslass der mindestens einen Prozesskammer und das mehrfache Aussetzen der Probe gegenüber dem Fokalbereich umfasst.

9. Verfahren gemäß einem der Ansprüche 6 oder 8, wobei das Fließenlassen eines Teils der Probe in dem Gefäß das Fließenlassen des Teils der Probe durch das Gefäß mit einer Rate von mindestens 0,1 mL/min oder zwischen etwa 0,5 mL/min und etwa 100 mL/min umfasst.

10. Verfahren gemäß einem der vorangegangenen Ansprüche, wobei die Probe ein bioaktives Mittel umfasst.

11. Verfahren gemäß einem der vorangegangenen Ansprüche, wobei das Übertragen fokussierter akustischer Energie, sodass die Probe mindestens teilweise im Fokalbereich liegt, das Übertragen fokussierter akustischer Energie mit einer Leistung von zwischen 50 Watt und 300 Watt umfasst.

12. Verfahren gemäß einem der vorangegangenen Ansprüche, das zusätzlich das Halten der Temperatur der Probe innerhalb eines vorgegebenen Bereichs während der Behandlung mit akustischer Energie umfasst.

13. Verfahren gemäß einem der vorangegangenen Ansprüche, das zusätzlich das Zirkulieren eines thermischen Transfermediums um eine Wand des Gefäßes in einem Volumen, das durch eine Ummantelung mindestens eines Teils des Gefäßes definiert ist, umfasst.

14. Verfahren gemäß einem der vorangegangenen Ansprüche, wobei das Übertragen fokussierter akustischer Energie durch die Wand des Gefäßes das Übertragen der akustischen Energie von einer akustischen Energiequelle zum Gefäß durch ein Kopplungsmedium und das Kontrollieren der Temperatur des Kopplungsmediums umfasst.

15. Verfahren gemäß einem der vorangegangenen Ansprüche, das zusätzlich das Re-Zirkulieren des Kopplungsmediums zum und vom Gefäß und durch einen Kühler oder Erhitzer, die zum Einstellen der Temperatur des Kopplungsmediums angewendet werden, umfasst.

16. Verfahren gemäß einem der vorangegangenen Ansprüche, das zusätzlich das Druckbeaufschlagen der Probe umfasst, sodass der Druck innerhalb des Gefäßes größer als der Druck außerhalb des Gefäßes ist.

17. Verfahren gemäß einem der vorangegangenen Ansprüche, wobei das Übertragen fokussierter akustischer Energie einen Arbeitszyklus von 50% einschließt.

## Revendications

1. Procédé de préparation d'une composition nanocristalline, comprenant :
une fourniture d'au moins une partie d'un échantillon comprenant un volume supérieur à 30 mL dans un récipient ;
une transmission d'énergie acoustique focalisée supérieure à 1000 cycles par salve présentant une fréquence comprise entre environ 100 kilohertz et environ 100 mégahertz et une zone focale présentant une dimension inférieure à environ 2 centimètres à travers une paroi du récipient de façon telle qu'au moins une partie de l'échantillon soit disposée dans la zone focale ; et
une formation, par l'intermédiaire d'une croissance cristalline, d'une pluralité de particules cristallines dans l'échantillon présentant une taille moyenne supérieure à environ 10 nm et un indice de polydispersité inférieur à 1.0, calculé selon la norme internationale ISO 13 321 de diffusion dynamique de la lumière, par exposition, au moins partielle, de l'échantillon à la zone focale.

2. Procédé selon la revendication 1, dans lequel la transmission d'énergie acoustique focalisée de façon telle que l'échantillon soit disposé au moins partiellement dans la zone focale comprend la transmission de l'énergie acoustique focalisée à des valeurs comprises entre 1000 cycles par salve et 6 000 cycles par salve, ou supérieures à 6 000 cycles par salve.

3. Procédé selon l'une quelconque des revendications précédentes, dans lequel l'échantillon est exposé à la zone focale pendant moins d'une heure.

4. Procédé selon l'une quelconque des revendications précédentes, dans lequel la pluralité de particules cristallines dans l'échantillon présente une taille moyenne comprise entre environ 10 nm et environ 1 micron.

5. Procédé selon l'une quelconque des revendications précédentes, dans lequel l'indice de polydispersité de la pluralité de particules cristallines dans l'échantillon, calculé selon la norme internationale ISO 13 321 de diffusion dynamique de la lumière, est compris entre environ 0,03 et environ 0,1, ou présente un écart type relatif inférieur à 1 % d'une taille de particules moyenne de la pluralité de particules cristallines.

6. Procédé selon l'une quelconque des revendications précédentes, comprenant en outre une génération d'un flux d'une partie de l'échantillon à travers au moins une chambre de traitement du récipient de façon telle que l'échantillon soit exposé à la zone focale pendant que celui-ci est disposé dans la au moins une chambre de traitement.

7. Procédé selon la revendication 6, dans lequel la au moins une chambre de traitement comprend une arrivée et une sortie agencées de façon telle que l'échantillon soit exposé à la zone focale pendant que celui-ci est disposé dans la au moins une chambre de traitement.

8. Procédé selon la revendication 6 ou 7, dans lequel une génération d'un flux d'une partie de l'échantillon à travers la au moins une chambre de traitement comprend la génération d'un flux d'une partie de l'échantillon à travers l'entrée et la sortie de la au moins une chambre de traitement et une exposition de l'échantillon, de multiples fois, à la zone focale.

9. Procédé selon l'une quelconque des revendications 6 et 8, dans lequel la génération d'un flux d'une partie de l'échantillon dans le récipient comprend la génération d'un flux d'une partie de l'échantillon à travers le récipient à un débit d'au moins 0,1 mL/min, ou compris entre environ 0,5 mL/min et environ 100 mL/min.

10. Procédé selon l'une quelconque des revendications précédentes, dans lequel l'échantillon comprend une substance biologiquement active.

11. Procédé selon l'une quelconque des revendications précédentes, dans lequel la transmission d'énergie acoustique focalisée de façon telle que l'échantillon soit disposé au moins partiellement dans la zone focale comprend la transmission de l'énergie acoustique focalisée à une puissance comprise entre 50 Watts et 300 Watts.

12. Procédé selon l'une quelconque des revendications précédentes, comprenant en outre un maintien d'une température de l'échantillon dans une plage prédéterminée pendant un traitement par énergie acoustique.

13. Procédé selon l'une quelconque des revendications précédentes, comprenant en outre une circulation d'un milieu de transfert thermique autour d'une paroi du récipient dans un volume défini par un gainage entourant au moins une partie du récipient.

14. Procédé selon l'une quelconque des revendications précédentes, dans lequel la transmission d'énergie acoustique focalisée à travers la paroi du récipient comprend la transmission de l'énergie acoustique à partir d'une source d'énergie acoustique au récipient par l'intermédiaire d'un milieu de couplage, et une commande de la température du milieu de couplage.

15. Procédé selon l'une quelconque des revendications précédentes, comprenant en outre une recirculation du milieu de couplage vers et hors du récipient et à travers un refroidisseur ou un dispositif de chauffage adapté pour régler une température du milieu de couplage.

16. Procédé selon l'une quelconque des revendications précédentes, comprenant en outre une soumission de l'échantillon à une mise sous pression de façon telle qu'une pression dans le récipient soit supérieure à une pression à l'extérieur du récipient.

17. Procédé selon l'une quelconque des revendications précédentes, dans lequel une transmission d'énergie acoustique focalisée comprend un cycle opératoire de 50%.
